# EUROPEAN PATENT APPLICATION

(11) **EP 4 686 097 A1**
(43) Date of publication of application: **28.01.2026**
(21) Application number: 25183223.4
(22) Date of filing: 17.06.2025
(51) Int. Cl.: H03K 3/356

(54) **LEVEL SHIFTER**

(30) Priority: 23.07.2024 KR 20240097433; 03.12.2024 KR 20240177897
(71) Applicant: Samsung Electronics Co., Ltd., Suwon-si, Gyeonggi-do 16677 (KR)
(72) Inventor: HEO, Donghun, 16677 Suwon-si (KR)
(74) Representative: Marks & Clerk LLP

(57) **Abstract**

Provided is a level shifter including: an inverting circuit configured to invert an input voltage and to output an inverted input voltage; a level shifting circuit configured to output first and second intermediate voltages, based on the input and inverted input voltages; and a buffer circuit configured to invert the first and second intermediate voltages, and to output an output voltage and an inverted output voltage, wherein the output and inverted output voltages swing between a first bias voltage and a power supply voltage, wherein the level shifting circuit includes an input protection circuit including input protection switching elements each including a gate terminal connected to a first or a second bias voltage line, and wherein the buffer circuit includes an output protection circuit including output protection switching elements each including a gate terminal connected to the first or second bias voltage line.

## Description

### TECHNICAL FIELD

The present invention generally relates to a level shifter. The disclosure particularly relates to a level shifter that changes a voltage domain of an input voltage and outputs a resultant voltage domain.

### BACKGROUND

Electronic devices may include a variety of components. Various devices may operate in the same voltage domain or in different voltage domains. Devices belonging to the same voltage domain may operate using the same power supply voltage and the same ground voltage. Devices belonging to different voltage domains may operate using power supply voltages having different voltage levels and ground voltages having different voltage levels.

To ensure normal operation of devices belonging to different voltage domains, level shifters may be used. A level shifter may convert a voltage (e.g., a voltage that swings between a first low voltage level and a first high voltage level) belonging to a voltage domain to a voltage (e.g., a voltage that swings between a second high voltage level and a second low voltage level) belonging to another voltage domain. The level shifter may malfunction as damage occurs to devices that operate based on a voltage generated by the level shifter. Therefore, various methods have been studied to reduce or prevent damage to the devices of the level shifter.

### SUMMARY

According to an aspect of the present invention, there is provided is a level shifter according to claim 1. According to another aspect of the present invention, there is provided is a level shifter according to claim 8. According to a further aspect of the present invention, there is provided is a level shifter according to claim 15. Preferred embodiments are defined by the dependent claims. It is further noted that an embodiment may be in accordance with a combination of any one or more of the independent claims and preferably any one or more dependent claims of such combined independent claims.

According to an aspect of the present invention, there is provided a level shifter that includes: an inverting circuit configured to invert an input voltage that swings between a first ground voltage and a first power supply voltage and to output an inverted input voltage; a level shifting stage circuit configured to output a first intermediate voltage and a second intermediate voltage, based on the input voltage and the inverted input voltage; and a buffer stage circuit configured to invert the first intermediate voltage and the second intermediate voltage, and to output an output voltage and an inverted output voltage, wherein the output voltage and the inverted output voltage swing between a first bias voltage and a second power supply voltage, wherein the level shifting stage circuit includes an input protection circuit including a plurality of input protection switching elements each including a gate terminal connected to a first bias voltage line or a second bias voltage line, and wherein the buffer stage circuit includes an output protection circuit including a plurality of output protection switching elements each including a gate terminal connected to the first bias voltage line or the second bias voltage line.

According to another aspect of the present invention, a level shifter is provided that includes: an inverting circuit configured to invert an input voltage that swings between a first ground voltage and a first power supply voltage and to output an inverted input voltage; a first stage circuit configured to output a first intermediate voltage and a second intermediate voltage based on the input voltage and the inverted input voltage, wherein the first intermediate voltage swings between a second power supply voltage and a first bias voltage, and wherein the second intermediate voltage is an inverted voltage of the first intermediate voltage; and a second stage circuit configured to invert the first intermediate voltage, and to output an output voltage that swings between the first bias voltage and the second power supply voltage, wherein the first stage circuit includes a first input circuit including a first input switching element connecting, to a first ground voltage line, one end of a first intermediate path including a node that outputs the first intermediate voltage to the second stage circuit, wherein the first input switching element is configured to be turned on based on the input voltage, wherein the first stage circuit further includes a second input switching element connecting, to the first ground voltage line, one end of a second intermediate path including a node that outputs the second intermediate voltage to the second stage circuit, and wherein the second input switching element is configured to be turned on based on the inverted input voltage.

According to an other aspect of the present invention, there is provided a level shifter that includes: an inverting circuit configured to invert an input voltage that swings between a first ground voltage and a first power supply voltage and to output an inverted input voltage; a first stage circuit configured to output a first intermediate voltage and a second intermediate voltage based on the input voltage and the inverted input voltage; and a second stage circuit configured to invert the first intermediate voltage and the second intermediate voltage to output an output voltage and an inverted output voltage, wherein the output voltage and the inverted output voltage swing between a first bias voltage and a second power supply voltage, and wherein the second stage circuit includes an output protection circuit configured to, based on the input voltage and the inverted input voltage, adjust the output voltage to the first bias voltage or adjust the inverted output voltage to the first bias voltage.

### BRIEF DESCRIPTION OF THE DRAWINGS

The above and other aspects and features of certain embodiments of the present invention will be more clearly understood from the following detailed description taken in conjunction with the accompanying drawings, in which:
FIG. 1 is a block diagram illustrating a level shifter according to one or more embodiments;
FIG. 2 is a block diagram illustrating a level shifter according to one or more embodiments;
FIG. 3 is a circuit diagram illustrating a level shifter according to one or more embodiments;
FIG. 4 is a table illustrating voltage changes according to levels of input voltages input to a level shifter according to one or more embodiments;
FIGS. 5 and 6 are diagrams illustrating a comparison between an embodiment and a comparative example;
FIG. 7 is a block diagram illustrating a bias voltage generating circuit of a level shifter according to an embodiment and a bias voltage generating circuit according to a comparative example;
FIG. 8 is a circuit diagram illustrating an example of a bias voltage generating circuit according to an embodiment and an example of a bias voltage generating circuit according to a comparative example;
FIG. 9 is a circuit diagram illustrating other examples of a bias voltage generating circuit according to one or more embodiments;
FIG. 10 is a circuit diagram illustrating another example of a first input circuit according to one or more embodiments;
FIG. 11 is a circuit diagram illustrating another example of a second input circuit according to one or more embodiments;
FIG. 12 is a circuit diagram illustrating another example of an output circuit according to one or more embodiments;
FIG. 13 is a block diagram of a computing system according to one or more embodiments; and
FIG. 14 is a diagram illustrating a system to which a storage device according to one or more embodiments is applied.

### DETAILED DESCRIPTION

Hereinafter, one or more embodiments are described in detail with reference to the accompanying drawings.

**In** the following description, like reference numerals refer to like elements throughout the specification. Terms such as "unit", "module", "member", and "block" may be embodied as hardware or software. As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element, wherein the indirect connection includes "connection via a wireless communication network".

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expressions "at least one of a, b or c" and "at least one of a, b and c" indicate "only a," "only b," "only c," "both a and b," "both a and c," "both b and c," and "all of a, b, and c."

It will be understood that, although the terms "first", "second", "third", etc., may be used herein to describe various elements, is the invention should not be limited by these terms. These terms are only used to distinguish one element from another element.

As used herein, the singular forms "a," "an" and "the" are intended to include the plural forms as well, unless the context clearly indicates otherwise.

We further note that the term "same" means "substantially the same", "completely" means "substantially completely", "equal" means "substantially equal", and numerical values such as "0V" or "0" generally mean "substantially 0V" or "substantially 0", wherein "substantially" means "substantially (e.g., exactly)".

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

Some embodiments provide is a level shifter that provides bias voltages to gate terminals of switching elements included in the level shifter, without generating bias voltages applied to drain and/or source terminals of the switching elements.

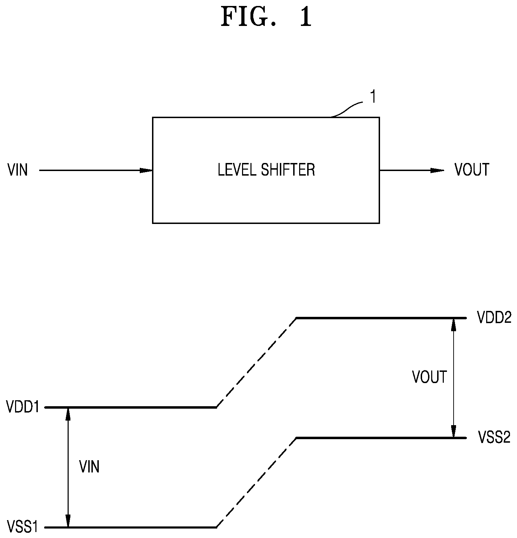

FIG. 1 is a block diagram illustrating a level shifter 1 according to one or more embodiments.

Referring to FIG. 1, the level shifter 1 according to one or more embodiments receives an input voltage VIN. The level shifter 1 converts a voltage level of the input voltage VIN to generate an output voltage VOUT. The level shifter 1 outputs the output voltage VOUT generated based on the input voltage VIN.

The input voltage VIN swings between a first ground voltage VSS1 and a first power supply voltage VDD1. The output voltage VOUT may swing between a second ground voltage VSS2 and a second power supply voltage VDD2.

The input voltage VIN may have the first ground voltage VSS1 or the first power supply voltage VDD1 depending on a preset duty ratio. For example, the input voltage VIN may have the first power supply voltage VDD1 during an ON duty period and the first ground voltage VSS1 during an OFF duty period. The second ground voltage VSS2 may be a higher voltage level than the first ground voltage VSS1, and the second power supply voltage VDD2 may be a higher voltage level than the first power supply voltage VDD1.

In the embodiment of FIG. 1, the first power supply voltage VDD1 may be a voltage level higher than the second ground voltage VSS2. However, embodiments are not limited thereto. In another embodiment, the first power supply voltage VDD1 may be the same voltage level as the second ground voltage VSS2, or the first power supply voltage VDD1 may be a lower voltage level than the second ground voltage VSS2.

The output voltage VOUT may have the second ground voltage VSS2 or the second power supply voltage VDD2 depending on the input voltage VIN. For example, if the input voltage VIN is at the first ground voltage VSS1 level, the output voltage VOUT may have the second ground voltage VSS2. When the input voltage VIN is at the first power supply voltage VDD1, the output voltage VOUT may have the second power supply voltage VDD2. However, embodiments are not limited thereto. In another example, if the input voltage VIN is at the first ground voltage VSS1, the output voltage VOUT may have the second power supply voltage VDD2. When the input voltage VIN is at the first power supply voltage VDD1, the output voltage VOUT may have the second ground voltage VSS2.

The level shifter 1 according to embodiments receives a first bias voltage VG1 and the first bias voltage VG1 may be defined as the second ground voltage VSS2.

Hereinafter, by way of example, it is described that the first bias voltage VG1 corresponds to the second ground voltage VSS2.

Hereinafter, an input voltage VIN line may refer to a line that electrically provides the input voltage VIN, a first ground voltage VSS1 line may refer to a line that electrically provides the first ground voltage VSS1, a first power supply voltage VDD1 line may refer to a line that electrically provides the first power supply voltage VDD1, a second ground voltage VSS2 line may refer to a line that electrically provides the second ground voltage VSS2, a second power supply voltage VDD2 line may refer to a line that electrically provides the second power supply voltage VDD2, a first bias voltage VG1 line may refer to a line that electrically provides a first bias voltage VG1, a second bias voltage VG2 line may refer to a line that electrically provides a second bias voltage VG2, a first intermediate voltage VMID1 line may refer to a line that electrically provides a first intermediate voltage VMID1, a second intermediate voltage VMID2 line may refer to a line that electrically provides a second intermediate voltage VMID2, an output voltage VOUT line may refer to a line that electrically provides an output voltage VOUT, and an inverted output voltage VOUTB line may refer to a line that electrically provides an inverted output voltage VOUT.

Also, within this disclosure, "ground" does not necessarily refer to a reference potential of 0V. The first ground voltage VSS1 may have a reference potential of the first ground voltage VSS1, and the second ground voltage VSS2 may have a reference potential of the second ground voltage VSS2. That is, the first ground voltage VSS1 and the second ground voltage VSS2 may have different reference potentials.

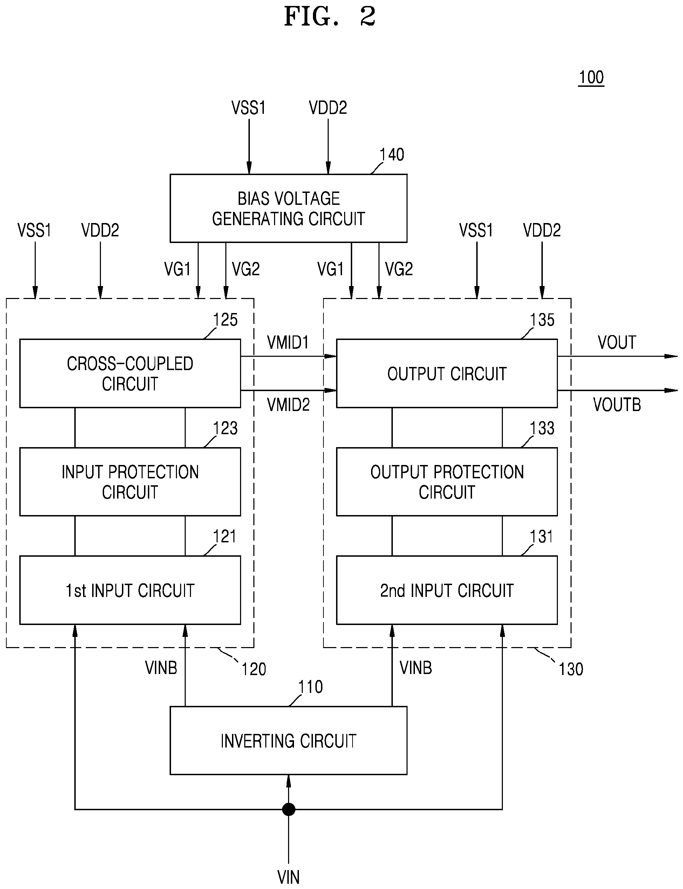

The level shifter 1 according to one or more embodiments may include an input protection circuit (123, FIG. 2) and an output protection circuit (133, FIG. 2), thereby reducing or preventing damage to a switching element within the level shifter 1.

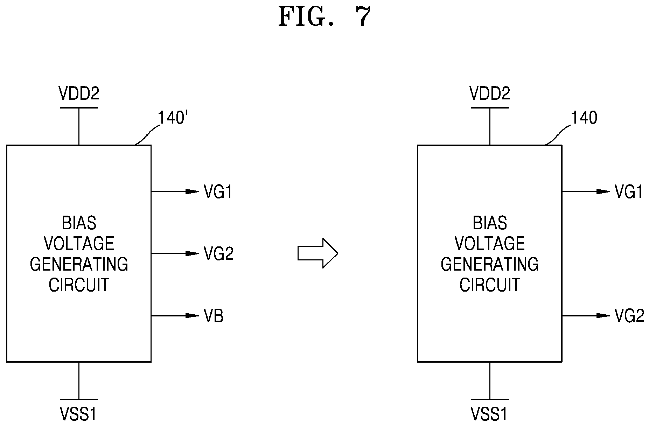

In the level shifter 1 according to one or more embodiments, bias voltages (VG1 and VG2, FIG. 7) are provided to gate terminals of switching elements included in the level shifter 1. In embodiments, this may be done without generating a bias voltage (VB, FIG. 7) applied to drain and/or source terminals of the switching elements, thereby in some embodiments allowing the level shifter 1 to significantly reduce current consumption.

In the level shifter 1 according to one or more embodiments, a current path is not formed between the first power supply voltage VDD1 line and the second power supply voltage VDD2 line, so that in some embodiments power may not be unnecessarily consumed.

Embodiments including those discussed above are described below in detail with reference to FIGS. 2 to 12.

FIG. 2 is a block diagram illustrating a level shifter 100 according to one or more embodiments.

Referring to FIG. 2, the level shifter 100 includes an inverting circuit 110, a first stage circuit 120 (this may generally be referred to as a level shifting circuit), a second stage circuit 130 (this may generally be referred to as a buffer circuit), and may include a bias voltage generating circuit 140.

The inverting circuit 110 inverts the input voltage VIN to output an inverted input voltage VINB. The inverting circuit 110 may provide the inverted input voltage VINB to the first stage circuit 120 and the second stage circuit 130.

In detail, the inverting circuit 110 receives an input voltage VIN that swings between the first ground voltage VSS1 and the first power supply voltage VDD1. The inverting circuit 110 inverts the input voltage to generate an inverted input voltage VINB. Here, the inverted input voltage VINB may also swing between the first ground voltage VSS1 and the first power supply voltage VDD1. When the voltage level of the input voltage VIN is the first ground voltage VSS1, the voltage level of the inverted input voltage VINB may be the first power supply voltage VDD1, and when the voltage level of the input voltage VIN is the first power supply voltage VDD1, the voltage level of the inverted input voltage VINB may be the first ground voltage VSS1.

An input terminal of the inverting circuit 110 may be connected to the input voltage VIN line. A power terminal of the inverting circuit 110 may be connected to the first power supply voltage VDD1 line. An output terminal of the inverting circuit 110 may be connected to a gate terminal of a second input switching element IT2 to be described below.

The first stage circuit 120 may be referred to as a level shifting stage circuit, and the first stage circuit 120 outputs the first and second intermediate voltages VMID1 and VMID2 based on the voltage level of the input voltage VIN and the voltage level of the inverted input voltage VINB.

The first stage circuit 120 may receive the first bias voltage VG1 and the second bias voltage VG2 from the bias voltage generating circuit 140. The first stage circuit 120 may receive the input voltage VIN and the inverted input voltage VINB from the inverting circuit 110. The first stage circuit 120 may be connected to the first ground voltage VSS1 line and grounded at the first ground voltage VSS1, and the first stage circuit 120 may be connected to the second power supply voltage VDD2 line and receive the second power supply voltage VDD2.

In embodiments, the first stage circuit 120 outputs the first intermediate voltage VMID1 and the second intermediate voltage VMID2 based on the voltage level of the input voltage VIN and the voltage level of the inverted input voltage VINB. Here, the first intermediate voltage VMID1 and the second intermediate voltage VMID2 may swing between the first bias voltage VG1 and the second power supply voltage VDD2. However, when the voltage level of the first intermediate voltage VMID1 is the first bias voltage VG1, the voltage level of the second intermediate voltage VMID2 may be the second power supply voltage VDD2, and when the voltage level of the first intermediate voltage VMID1 is the second power supply voltage VDD2, the voltage level of the second intermediate voltage VMID2 may be the first bias voltage VG1.

The second stage circuit 130 may be referred to as a buffer stage circuit and inverts the first and second intermediate voltages VMID1 and VMID2 to output voltages VOUT and VOUTB. Here, voltage characteristics (e.g., voltage magnitude, voltage stability, voltage fluctuation, etc.) of the first and second intermediate voltages VMID1 and VMID2 of embodiments may be improved so that preferred or improved output voltages VOUT and VOUTB may be output.

The second stage circuit 130 may receive the first bias voltage VG1 and the second bias voltage VG2 from the bias voltage generating circuit 140. The second stage circuit 130 receives the input voltage VIN and receives the inverted input voltage VINB from the inverting circuit 110. The second stage circuit 130 may be connected to the first ground voltage VSS1 line and be grounded at the first ground voltage VSS1, and the second stage circuit 130 may be connected to the second power supply voltage VDD2 line and receive the second power supply voltage VDD2. The second stage circuit 130 receives the first intermediate voltage VMID1 and the second intermediate voltage VMID2 from the first stage circuit 120.

The second stage circuit 130 may invert the voltage level of the first intermediate voltage VMID1 to output the output voltage VOUT. The second stage circuit 130 may invert the voltage level of the second intermediate voltage VMID2 to output the inverted output voltage VOUTB.

Here, the output voltage VOUT and the inverted output voltage VOUTB may swing between the first bias voltage VG1 and the second power supply voltage VDD2. However, when the voltage level of the output voltage VOUT is the first bias voltage VG1, the voltage level of the inverted output voltage VOUTB may be the second power supply voltage VDD2, and/or when the voltage level of the output voltage VOUT is the second power supply voltage VDD2, the voltage level of the inverted output voltage VOUTB may be the first bias voltage VG1.

In embodiments, the second stage circuit 130 outputs the output voltage VOUT and the inverted output voltage VOUTB based on the voltage level of the first intermediate voltage VMID1, the voltage level of the second intermediate voltage VMID2, the voltage level of the input voltage VIN, and the voltage level of the inverted input voltage VINB.

The bias voltage generating circuit 140 of embodiments may generate various types of voltages. The bias voltage generating circuit 140 may be connected to the first ground voltage VSS1 line and may be grounded at the first ground voltage VSS1, and the bias voltage generating circuit 140 may be connected to the second power supply voltage VDD2 line and may receive the second power supply voltage VDD2. The bias voltage generating circuit 140 may generate the first bias voltage VG1 and the second bias voltage VG2 based on the second power supply voltage VDD2 and the first ground voltage VSS1. The first bias voltage VG1 and the second bias voltage VG2 generated by the bias voltage generating circuit 140 may be input to the first stage circuit 120 and the second stage circuit 130. A more detailed structure and operation of the bias voltage generating circuit 140 are described below with reference to FIGS. 7 to 9.

In the embodiment of FIG. 2, the bias voltage generating circuit 140 is illustrated as being located inside the level shifter 100, but embodiments are not limited thereto. Unlike the embodiment of FIG. 1, the bias voltage generating circuit 140 may be implemented separately outside the level shifter 100.

Referring to FIG. 2, the first stage circuit 120 may include preferably each of a first input circuit 121, an input protection circuit 123, and a cross-coupled circuit 125. Here, the first stage circuit 120 may include two intermediate paths connecting the first ground voltage VSS1 line to the second power supply voltage VDD2 line, a first intermediate path including a node outputting the first intermediate voltage VMID1 and a second intermediate path including a node outputting the second intermediate voltage VMID2.

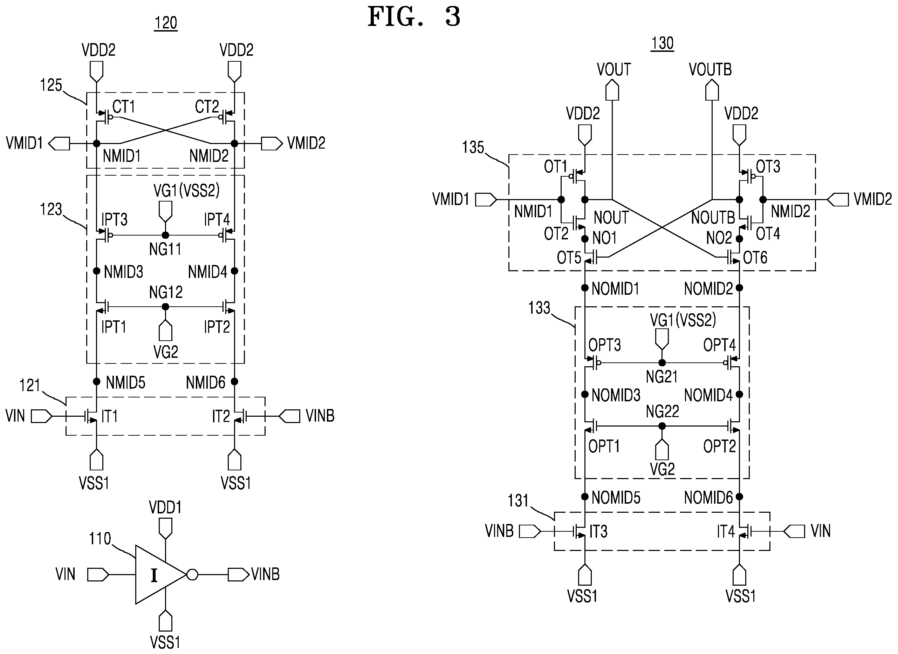

The first input circuit 121 may connect (or disconnect) the first ground voltage VSS1 line to (or from) the first intermediate path described above, based on the voltage level of the input voltage VIN. The first input circuit 121 may connect (or disconnect) the first ground voltage VSS1 line to (or from) the second intermediate path described above, based on the voltage level of the inverted input voltage VINB. Here, the first input circuit 121 may be connected between the first ground voltage VSS1 line and the input protection circuit 123. A detailed structure and operation of the first input circuit 121 are described below with reference to FIG. 3 and the subsequent drawings.

The input protection circuit 123 may adjust the voltage level of the first intermediate voltage VMID1 to the level of the first bias voltage VG1 or adjust the voltage level of the second intermediate voltage VMID2 to the level of the first bias voltage VG1, based on the voltage level of the input voltage VIN and the voltage level of the inverted input voltage VINB.

In one or more embodiments, the input protection circuit 123 may include a plurality of input protection switching elements in which the first bias voltage VG1 line or the second bias voltage VG2 line is connected to a gate terminal. The input protection circuit 123 may be connected between the first input circuit 121 and the cross-coupled circuit 125. When one of the two paths constituting the input protection circuit 123 is connected to the first ground voltage VSS1 line by the first input circuit 121, the other path may be disconnected from the first ground voltage VSS1 line. When the path connected to the first ground voltage VSS1 line is the first intermediate path including a node outputting the first intermediate voltage VMID1, the voltage level of the first intermediate voltage VMID1 may be adjusted to the first bias voltage VG1. Conversely, if the path connected to the first ground voltage VSS1 line is the second intermediate path including a node outputting the second intermediate voltage VMID2, the voltage level of the second intermediate voltage VMID2 may be adjusted to the first bias voltage VG1.

One path connected to the first ground voltage VSS1 line may be disconnected from the second power supply voltage VDD2 line by the cross-coupled circuit 125, and may be connected to the second power supply voltage VDD2 line by another cross-coupled circuit 125 disconnected from the first ground voltage VSS1 line.

A detailed structure and operation of the input protection circuit 123 are described below with reference to FIG. 3 and the subsequent drawings.

The cross-coupled circuit 125 may adjust the voltage level of the first intermediate voltage VMID1 to the second power supply voltage VDD2 or adjust the voltage level of the second intermediate voltage VMID2 to the second power supply voltage VDD2, based on the voltage level of the input voltage VIN and the voltage level of the inverted input voltage VINB.

In detail, the cross-coupled circuit 125 may be connected between the second power supply voltage VDD2 line and the input protection circuit 123. The cross-coupled circuit 125 may adjust another voltage level that is not adjusted by the input protection circuit 123 among the first intermediate voltage VMID1 and the second intermediate voltage VMID2. For example, when the input protection circuit 123 adjusts the voltage level of the first intermediate voltage VMID1 to the first bias voltage VG1, the cross-coupled circuit 125 may adjust the voltage level of the second intermediate voltage VMID2 to the second power supply voltage VDD2. Conversely, when the input protection circuit 123 adjusts the voltage level of the second intermediate voltage VMID2 to the first bias voltage VG1, the cross-coupled circuit 125 may adjust the voltage level of the first intermediate voltage VMID1 to the second power supply voltage VDD2. A detailed structure and operation of the cross-coupled circuit 125 are described below with reference to FIG. 3 and the subsequent drawings.

Referring to FIG. 2, the second stage circuit 130 may include preferably each of a second input circuit 131, an output protection circuit 133, and an output circuit 135. Here, the second stage circuit 130 may include two paths connecting the first ground voltage VSS1 line to the second power supply voltage VDD2 line, an output path may include a node outputting the output voltage VOUT, and an inverting output path may include a node outputting the inverted output voltage VOUTB.

The second input circuit 131 may connect (or disconnect) the first ground voltage VSS1 line to (or from) the output path based on the voltage level of the input voltage VIN. The second input circuit 131 may connect (or disconnect) the first ground voltage VSS1 line to the inverting output path described above, based on the voltage level of the inverted input voltage VINB. Here, the second input circuit 131 may be connected between the first ground voltage VSS1 line and the output protection circuit 133. A detailed structure and operation of the second input circuit 131 are described below with reference to FIG. 3 and the subsequent drawings.

The output protection circuit 133 may be substantially a replica circuit of the input protection circuit 123. That is, the output protection circuit 133 may have a design and operating principle similar to those of the input protection circuit 123.

The output protection circuit 133 may adjust the voltage level of the output voltage VOUT to the first bias voltage VG1 or adjust the voltage level of the inverted output voltage VOUTB to the first bias voltage VG1, based on the voltage level of the input voltage VIN and the voltage level of the inverted input voltage VINB.

In detail, the output protection circuit 133 may include a plurality of output protection switching elements. The output protection circuit 133 may be connected between the second input circuit 131 and the output circuit 135. If one of the two paths constituting the output protection circuit 133 is connected to the first ground voltage VSS1 line by the second input circuit 131, the other path may be disconnected from the first ground voltage VSS1 line. When the path connected to the first ground voltage VSS1 line is an output path including a node that outputs the output voltage VOUT, the voltage level of the output voltage VOUT may be adjusted to the first bias voltage VG1. Conversely, if the path connected to the first ground voltage VSS1 line is an inverting output path including a node that outputs the inverted output voltage VOUTB, the voltage level of the inverted output voltage VOUTB may be adjusted to the first bias voltage VG1.

One path connected to the first ground voltage VSS1 line may be disconnected from the second power supply voltage VDD2 line by the output circuit 135, and the other path disconnected from the first ground voltage VSS1 line may be connected to the second power supply voltage VDD2 line by the output circuit 135.

A detailed structure and operation of the output protection circuit 133 are described below with reference to FIG. 3 and the subsequent drawings.

The output circuit 135 may invert the first intermediate voltage VMID1 to output the output voltage VOUT. The output circuit 135 may invert the second intermediate voltage VMID2 to output the inverted output voltage VOUTB.

In one or more embodiments, the output circuit 135 may be connected to the cross-coupled circuit 125. The output circuit 135 may receive the first intermediate voltage VMID1 and the second intermediate voltage VMID2 from the cross-coupled circuit 125.

The output circuit 135 may be connected between the second power supply voltage VDD2 line and the output protection circuit 133. The output circuit 135 may adjust the voltage level of the output voltage VOUT to the second power supply voltage VDD2 or adjust the voltage level of the inverted output voltage VOUTB to the second power supply voltage VDD2, based on the voltage level of the first intermediate voltage VMID1 and the voltage level of the second intermediate voltage VMID2. The output circuit 135 may output, as the output voltage VOUT, the first bias voltage VG1 by the output protection circuit 133 or may output, as the inverted output voltage VOUTB, the first bias voltage VG1 by the output protection circuit 133, based on the voltage level of the first intermediate voltage VMID1 and the voltage level of the second intermediate voltage VMID2. A detailed structure and operation of the output circuit 135 are described below with reference to FIG. 3 and the subsequent drawings.

FIG. 3 is a circuit diagram illustrating the level shifter 100 according to one or more embodiments.

Referring to FIG. 3, the level shifter 100 includes the inverting circuit 110, and may include preferably each of the first input circuit 121, the input protection circuit 123, the cross-coupled circuit 125, the second input circuit 131, the output protection circuit 133, and/or the output circuit 135. The level shifter 100 may further include the bias voltage generating circuit 140.

A plurality of switching elements included in the embodiment of FIG. 3 may include metal oxide silicon field effect transistors (MOSFETs), but embodiments are not limited thereto. However, the following description focuses on an embodiment in which the plurality of switching elements include MOSFETs.

Hereinafter, the first ground voltage VSS1 may be a voltage level that may turn off an NMOS transistor, and for example, the first ground voltage VSS1 may be 0 V. The first power supply voltage VDD1 may be a voltage level that may turn on the NMOS transistor, and for example, the first power supply voltage VDD1 may be 0.7 V. The second ground voltage VSS2 may be a voltage level that may turn on a PMOS transistor. For example, the second ground voltage VSS2 may be 0.5 V. The second power supply voltage VDD2 may be a voltage level that may turn off the PMOS transistor, and for example, the second power supply voltage VDD2 may be 1.2 V. For example, the second bias voltage VG2 may be 0.7 V, and the first bias voltage VG1 may be 0.5 V.

Referring to FIG. 3, the inverting circuit 110 may be implemented as an inverter I. The inverter I may be connected between the first ground voltage VSS1 line and the first power supply voltage VDD1 line. An input terminal of the inverter I may be connected to the input voltage VIN line. An output terminal of the inverter I may be connected to the first input circuit 121 and the second input circuit 131. The inverter I may invert the input voltage VIN and output the inverted input voltage VINB.

In one or more embodiments, the inverter I may invert the input voltage VIN to generate the inverted input voltage VINB. For example, when the input voltage VIN is at the first ground voltage VSS1, the inverter I may generate the inverted input voltage VINB having the first power supply voltage VDD1. When the input voltage VIN is at the first power supply voltage VDD1, the inverter I may generate the inverted input voltage VINB having the first ground voltage VSS1. The inverter I may output the generated inverted input voltage VINB to the first input circuit 121 and the second input circuit 131. The inverter I may be physically implemented by analog and/or digital circuits such as logic gates, integrated circuits, microprocessors, microcontrollers, memory circuits, passive electronic components, active electronic components, hardwired circuits and the like, and may optionally be driven by a firmware. The inverter may, for example, be embodied in one or more semiconductor chips, or on substrate supports such as printed circuit boards and the like.

Referring to FIG. 3, the input terminal of the inverter I may be connected to the input voltage VIN line. A power terminal of the inverter I may be connected to the first power supply voltage VDD1 line. The output terminal of the inverter I may be connected to a gate terminal of a second input switching element IT2 to be described below.

Referring to FIG. 3, the first input circuit 121 may include preferably both of a first input switching element IT1 and the second input switching element IT2.

The first input switching element IT1 may be an NMOS transistor. A gate terminal of the first input switching element IT1 may be connected to the input voltage VIN line. Here, the first input switching element IT1 may be turned on or off based on the voltage level of the input voltage VIN. A source terminal of the first input switching element IT1 may be connected to the first ground voltage VSS1 line. Here, the first input switching element IT1 may be grounded to the first ground voltage VSS1 through the source terminal. A drain terminal of the first input switching element IT1 may be connected to a node NMID5 and may be connected to a first input protection switching element IPT1 to be described below. Referring to FIG. 3, the first input switching element IT1 may connect one end of the first intermediate path including a node NMID1 outputting the first intermediate voltage VMID1 (a path between the node NMID1 and the node NMI5) to the first ground voltage VSS1 line.

The first input switching element IT1 may be turned on when the input voltage VIN having the first power supply voltage VDD1 is applied through a gate terminal of the first input switching element IT1. Here, the node NMID5 connected to the drain terminal of the first input switching element IT1 may be grounded at the first ground voltage VSS1 through the source terminal of the first input switching element IT1 and may have the first ground voltage VSS1. Conversely, the first input switching element IT1 may be turned off when the input voltage VIN having the first ground voltage VSS1 is applied through the gate terminal of the first input switching element IT1.

The second input switching element IT2 may be an NMOS transistor. A gate terminal of the second input switching element IT2 may be connected to the inverted input voltage VINB line. Here, the second input switching element IT2 may be turned on or off based on the voltage level of the inverted input voltage VINB. A source terminal of the second input switching element IT2 may be connected to the first ground voltage VSS1 line. Here, the second input switching element IT2 may be grounded at the first ground voltage VSS1 through the source terminal of second input switching element IT2. A drain terminal of the second input switching element IT2 may be connected to a node NMID6 and may be connected to a second input protection switching element IP2 to be described below. Referring to FIG. 3, the second input switching element IT2 may connect one end of the second intermediate path including a node NMID2 outputting the second intermediate voltage VMID2 (a path between the node NMID2 and a node NMI6) to the first ground voltage VSS1 line.

The second input switching element IT2 may be turned on when the inverted input voltage VINB having the first power supply voltage VDD1 is applied through the gate terminal. Here, the node NMID6 connected to the drain terminal of the second input switching element IT2 may be grounded at the first ground voltage VSS1 through the source terminal of the second input switching element IT2 and may have the first ground voltage VSS1. Conversely, the second input switching element IT2 may be turned off when the inverted input voltage VINB having the first ground voltage VSS1 is applied through the gate terminal.

When the input voltage VIN has the first power supply voltage VDD1, the inverted input voltage VINB has the first ground voltage VSS1, so the first input switching element IT1 and the second input switching element IT2 may operate complementarily. That is, when the first input switching element IT1 is turned on, the second input switching element IT2 may be turned off. When the first input switching element IT1 is turned off, the second input switching element IT2 may be turned on.

That is, the first input circuit 121 may connect or disconnect one end of the first intermediate path (a path between the node NMID1 and the node NMI5) including the node NMID1 that outputs the first intermediate voltage VMID1 to the second stage circuit 130 (or buffer stage circuit) based on the voltage level of the input voltage VIN to or from the first ground voltage VSS1 line. The first input circuit 121 may connect or disconnect one end of the second intermediate path (path between the node NMID2 and the node NMI6) including the node NMID2 that outputs the second intermediate voltage VMID2 to the second stage circuit 130 (or buffer stage circuit) based on the voltage level of the inverted input voltage VINB to or from the first ground voltage VSS1 line.

The input protection circuit 123 may include multiple input protection switching elements such as first to fourth input protection switching elements IPT1 to IPT4.

The first input protection switching element IPT1 may be an NMOS transistor. A gate terminal of the first input protection switching element IPT1 may be connected to the second bias voltage VG2 line. The gate terminal of the first input protection switching element IPT1 may be connected to a node NG12 to which the second bias voltage VG2 is applied. A source terminal of the first input protection switching element IPT1 may be connected to the node NMID5 and may be connected to the first input switching element IT1. A drain terminal of the first input protection switching element IPT1 may be connected to the node NMID3 and may be connected to the third input protection switching element IPT3.

When the node NMID5 is grounded at the first ground voltage VSS1 from the drain terminal of the first input switching element IT1, the node NMID3 connected to the drain terminal of the first input protection switching element IPT1 may have the first ground voltage VSS1. Here, the first input protection switching element IPT1 is an NMOS transistor, and because in embodiments the second bias voltage VG2 that is sufficiently higher than the source voltage is applied through the gate terminal of first input protection switching element IPT1, a gate-source voltage VGS may exceed a threshold voltage so that the first input protection switching element IPT1 may be maintained in a turn-on state.

Conversely, when a voltage having the second power supply voltage VDD2 is applied from the drain terminal of the third input protection switching element IPT3 to the node NMID3, the node NMID5 connected to the source terminal of the first input protection switching element IPT1 may have the second bias voltage VG2. In embodiments, this is because the voltage level of the node NMID5 connected to the source terminal of the first input protection switching element IPT1 increases to the second bias voltage VG2 as current (or leakage current) may flow until the gate-source voltage VGS of the first input protection switching element IPT1 may become 0. That is, in embodiments, because the voltage level of the node NMID5 connected to the source terminal of the first input protection switching element IPT1 becomes the second bias voltage VG2, the gate-source voltage VGS of the first input protection switching element IPT1 may become 0 so that the first input protection switching element IPT1 of some embodiments may be completely turned off.

The second input protection switching element IPT2 may be an NMOS transistor. A gate terminal of the second input protection switching element IPT2 may be connected to the second bias voltage VG2 line. Referring to FIG. 3, the gate terminal of the second input protection switching element IPT2 may be connected to a node NG12 to which the second bias voltage VG2 is applied. A source terminal of the second input protection switching element IPT2 may be connected to the node NMID6 and may be connected to the second input switching element IT2. A drain terminal of the second input protection switching element IPT2 may be connected to the node NMID4 and may be connected to the fourth input protection switching element IPT4.

When the node NMID6 is grounded at the first ground voltage VSS1 from the voltage of the drain terminal of the second input switching element IT2, the node NMID3 connected to the drain terminal of the second input protection switching element IPT2 may have the first ground voltage VSS1. Here, the second input protection switching element IPT2 is an NMOS transistor, and because in embodiments the second bias voltage VG2 that is sufficiently higher than the source voltage is applied through the gate terminal, the gate-source voltage VGS may exceed the threshold voltage so that the second input protection switching element IPT2 of some embodiments is maintained in a turn-on state.

Conversely, when a voltage having the second power supply voltage VDD2 is applied from the drain terminal of the fourth input protection switching element IPT4 to the node NMID4, the node NMID6 connected to the source terminal of the second input protection switching element IPT2 may have the second bias voltage VG2. In embodiments, this is because the voltage level of the node NMID6 connected to the source terminal of the second input protection switching element IPT2 increases to the second bias voltage VG2 as current (or leakage current) may flow until the gate-source voltage VGS of the second input protection switching element IPT2 may become 0. That is, in embodiments, because the voltage level of the node NMID6 connected to the source terminal of the second input protection switching element IPT2 becomes the second bias voltage VG2, the gate-source voltage VGS of the second input protection switching element IPT2 may become 0 so that the second input protection switching element IPT2 may in some embodiments be completely turned off.

The first input protection switching element IPT1 and the second input protection switching element IP2 may operate complementarily. That is, when the first input protection switching element IPT1 is turned on, the second input protection switching element IP2 may be turned off. When the first input protection switching element IPT1 is turned off, the second input protection switching element IP2 may be turned on.

The third input protection switching element IPT3 may be a PMOS transistor. The gate terminal of the third input protection switching element IPT3 may be connected to the first bias voltage VG1 line. The gate terminal of the third input protection switching element IPT3 may be connected to a node NG11 to which the first bias voltage VG1 is applied. A source terminal of the third input protection switching element IPT3 may be connected to the node NMID1 and may be connected to a first cross-switching element CT1 of the cross-coupled circuit 125 and the output circuit 135. A drain terminal of the third input protection switching element IPT3 may be connected to the node NMID3 and may be connected to the first input protection switching element IPT1.

When the node NMID3 is grounded at the first ground voltage VSS1 from the drain terminal of the first input protection switching element IPT1, the node NMID1 connected to the source terminal of the third input protection switching element IPT3 may have the first bias voltage VG1. In embodiments, this is because the voltage level of the node NMID1 connected to the source terminal of the third input protection switching element IPT3 is lowered to the first bias voltage VG1 as current (or leakage current) may flow until the gate-source voltage VGS of the third input protection switching element IPT3 may become 0. That is, in embodiments, because the voltage level of the node NMID1 connected to the source terminal of the third input protection switching element IPT3 becomes the first bias voltage VG1, the gate-source voltage VGS of the third input protection switching element IPT3 may become 0, and thus, the third input protection switching element IPT3 may in some embodiments be completely turned off.

Conversely, when a voltage having the second power supply voltage VDD2 is applied from the drain terminal of the first cross-switching element CT1 to the node NMID1, the node NMID3 connected to the drain terminal of the third input protection switching element IPT3 may have the second power supply voltage VDD2. Here, the third input protection switching element IPT3 is a PMOS transistor, and because in embodiments the first bias voltage VG1 that is sufficiently lower than the source voltage is applied through the gate terminal, the source-gate voltage VSG may exceed the threshold voltage so that the third input protection switching element IPT3 is in embodiments maintained in a turn-on state.

The fourth input protection switching element IPT4 may be a PMOS transistor. A gate terminal of the fourth input protection switching element IPT4 may be connected to the first bias voltage VG1 line. Referring to FIG. 3, the gate terminal of the fourth input protection switching element IPT4 may be connected to a node NG11 to which the first bias voltage VG1 is applied. A source terminal of the fourth input protection switching element IPT4 may be connected to the node NMID2 and may be connected to a second cross-switching element CT2 of the cross-coupled circuit 125 and the output circuit 135. A drain terminal of the fourth input protection switching element IPT4 may be connected to the node NMID4 and may be connected to the second input protection switching element IPT2.

When the node NMID4 is grounded at the first ground voltage VSS1 from the drain terminal of the second input protection switching element IPT2, the node NMID2 connected to the source terminal of the fourth input protection switching element IPT4 may have the first bias voltage VG1. In embodiments, this is because the voltage level of the node NMID2 connected to the source terminal of the fourth input protection switching element IPT4 is lowered to the first bias voltage VG1 as current (or leakage current) may flow until the gate-source voltage VGS of the fourth input protection switching element IPT4 may become 0. That is, in embodiments, because the voltage level of the node NMID2 connected to the source terminal of the fourth input protection switching element IPT4 becomes the first bias voltage VG1, the gate-source voltage VGS of the fourth input protection switching element IPT4 may become 0, and thus, the fourth input protection switching element IPT4 may in some embodiments be completely turned off.

Conversely, when a voltage having the second power supply voltage VDD2 is applied from the drain terminal of the second cross-switching element CT2 to the node NMID2, the node NMID4 connected to the drain terminal of the fourth input protection switching element IPT4 may have the second power supply voltage VDD2. Here, the fourth input protection switching element IPT4 is a PMOS transistor, and because in embodiments the first bias voltage VG1 that is sufficiently lower than the source voltage is applied through the gate terminal, the source-gate voltage VSG may exceed the threshold voltage so that the fourth input protection switching element IPT4 of some embodiments is maintained in a turn-on state.

The third input protection switching element IPT3 and the fourth input protection switching element IP4 may operate complementarily. That is, when the third input protection switching element IPT3 is turned on, the fourth input protection switching element IP4 may be turned off. When the third input protection switching element IPT3 is turned off, the fourth input protection switching element IP4 may be turned on.

The first input protection switching element IPT1 and the third input protection switching element IPT3 may operate complementarily. That is, when the first input protection switching element IPT1 is turned on, the third input protection switching element IPT3 may be turned off. When the first input protection switching element IPT1 is turned off, the third input protection switching element IPT3 may be turned on. Similarly, the second input protection switching element IPT2 and the fourth input protection switching element IP4 may also operate complementarily.

Referring to FIG. 3, the cross-coupled circuit 125 may include preferably both of the first cross-switching element CT1 and the second cross-switching element CT2.

The first cross-switching element CT1 may be a PMOS transistor. The gate terminal of the first cross-switching element CT1 may be connected to the node NMID2. Here, the first cross-switching element CT1 may be turned on or off based on the second intermediate voltage VMID2 output to the node NMID2. The source terminal of the first cross-switching element CT1 may be connected to the second power supply voltage VDD2 line. The drain terminal of the first cross-switching element CT1 may be connected to the node NMID1.

The first cross-switching element CT1 may be turned on when the second intermediate voltage VMID2 having the second ground voltage VSS2 is applied through the gate terminal of the first cross-switching element CT1. Here, because in embodiments the second power supply voltage VDD2 is applied through the source terminal of the first cross switching element CT1, the first intermediate voltage VMID1 output to the node NMID1 connected to the drain terminal of the first cross switching element CT1 may have the second power supply voltage VDD2. Conversely, the first cross-switching element CT1 may be turned off in embodiments when the second intermediate voltage VMID2 having the second power supply voltage VDD2 is applied through the gate terminal.

The second cross-switching element CT2 may be a PMOS transistor. The gate terminal of the second cross-switching element CT2 may be connected to the node NMID1. Here, the second cross-switching element CT2 may be turned on or off based on the first intermediate voltage VMID1 output to the node NMID1. The source terminal of the second cross-switching element CT2 may be connected to the second power supply voltage VDD2 line. The drain terminal of the second cross-switching element CT2 may be connected to the node NMID2.

The second cross-switching element CT2 may be turned on when the first intermediate voltage VMID1 having the second ground voltage VSS2 is applied through a gate terminal. Here, because in embodiments the second power supply voltage VDD2 is applied through the source terminal of the second cross switching element CT2, the second intermediate voltage VMID2 output to the node NMID2 connected to the drain terminal of the second cross switching element CT2 may in embodiments have the second power supply voltage VDD2. Conversely, the second cross-switching element CT2 may be turned off when the first intermediate voltage VMID1 having the second power supply voltage VDD2 is in embodiments applied through the gate terminal.

The second input circuit 131 may include a third input switching element IT3 and a fourth input switching element IT4.

The third input switching element IT3 may be an NMOS transistor. A gate terminal of the third input switching element IT3 may be connected to the inverted input voltage VINB line. Here, the third input switching element IT3 may be turned on or off based on the voltage level of the inverted input voltage VINB. A source terminal of the third input switching element IT3 may be connected to the first ground voltage VSS1 line. Here, the third input switching element IT3 may be grounded at the first ground voltage VSS1 through the source terminal of the third input switching element IT3. A drain terminal of the third input switching element IT3 may be connected to a node NOMID5 and may be connected to a first output protection switching element OP1 to be described below. Referring to FIG. 3, the third input switching element IT3 may connect one end of an output path including a node NOUT that outputs the output voltage VOUT (a path between node the NOUT and the node NOMI5) to the first ground voltage VSS1 line.

The third input switching element IT3 may be turned on when the inverted input voltage VINB having the first power supply voltage VDD1 is applied through the gate terminal. Here, the node NOMID5 connected to the drain terminal of the third input switching element IT3 may be grounded at the first ground voltage VSS1 through the source terminal of the third input switching element IT3 and may have the first ground voltage VSS1. Conversely, the third input switching element IT3 may be turned off when the inverted input voltage VINB having the first ground voltage VSS1 is applied through the gate terminal.

The fourth input switching element IT4 may be an NMOS transistor. A gate terminal of the fourth input switching element IT4 may be connected to the input voltage VIN line. Here, the fourth input switching element IT4 may be turned on or off based on the voltage level of the input voltage VIN. A source terminal of the fourth input switching element IT4 may be connected to the first ground voltage VSS1 line. Here, the fourth input switching element IT4 may be grounded at the first ground voltage VSS1 through the source terminal. A drain terminal of the fourth input switching element IT4 may be connected to a node NOMID6 and may be connected to a second output protection switching element OP2 to be described below. Referring to FIG. 3, the fourth input switching element IT4 may connect one end of an inverting output path including a node NOUTB that outputs the inverted output voltage VOUTB (a path between the node NOUTB and the node NOMI6) and the first ground voltage VSS1 line.

The fourth input switching element IT4 may be turned on when the input voltage VIN having the first power supply voltage VDD1 is applied through the gate terminal. Here, the node NOMID6 connected to the drain terminal of the fourth input switching element IT4 may be grounded at the first ground voltage VSS1 through the source terminal of the fourth input switching element IT4 and may have the first ground voltage VSS1. Conversely, the fourth input switching element IT4 may be turned off when the input voltage VIN having the first ground voltage VSS1 is applied through the gate terminal.

When the input voltage VIN has the first power supply voltage VDD1, the inverted input voltage VINB has the first ground voltage VSS1, and thus, the third input switching element IT3 and the fourth input switching element IT4 may operate complementarily. That is, when the third input switching element IT3 is turned on, the fourth input switching element IT4 may be turned off. When the third input switching element IT3 is turned off, the fourth input switching element IT4 may be turned on.

That is, the second input circuit 131 may connect or disconnect one end of an output path (path between the node NOUT and the node NOMI5) including the node NOUT that outputs the output voltage VOUT based on the voltage level of the input voltage VIN to or from the first ground voltage VSS1 line. The second input circuit 131 may connect or disconnect one end of an inverting output path (path between the node NOUTB and the node NOMI6) including the node NMID2 that outputs the inverted output voltage VOUTB based on the voltage level of the inverted input voltage VINB to or from the first ground voltage VSS1 line.

Referring to FIG. 3, the output protection circuit 133 may include multiple output protection switching elements such as first to fourth output protection switching elements OPT1 to OPT4.

The first output protection switching element OPT1 may be an NMOS transistor. A gate terminal of the first output protection switching element OPT1 may be connected to the second bias voltage VG2 line. Referring to FIG. 3, the gate terminal of the first output protection switching element OPT1 may be connected to a node NG22 to which the second bias voltage VG2 is applied. A source terminal of the first output protection switching element OPT1 may be connected to the node NOMID5 and may be connected to the third input switching element IT3. A drain terminal of the first output protection switching element OPT1 may be connected to the node NOMID3 and may be connected to the third output protection switching element OPT3.

When the node NOMID5 is grounded at the first ground voltage VSS1 from the drain terminal of the third input switching element IT3, the node NOMID3 connected to the drain terminal of the first output protection switching element OPT1 may have the first ground voltage VSS1. Here, the first output protection switching element OPT1 is an NMOS transistor, and because in embodiments the second bias voltage VG2 that is sufficiently higher than the source voltage is applied through the gate terminal, the gate-source voltage VGS may exceed the threshold voltage so that the first output protection switching element OPT1 in some embodiments is maintained in a turn-on state.

Conversely, when a voltage having the second power supply voltage VDD2 is applied from the drain terminal of the third output protection switching element OPT3 to the node NOMID3, the node NOMID5 connected to the source terminal of the first output protection switching element OPT1 may have the second bias voltage VG2. This is because in embodiments the voltage level of the node NOMID5 connected to the source terminal of the first output protection switching element OPT1 increases to the second bias voltage VG2 as current (or leakage current) may flow until the gate-source voltage VGS of the first output protection switching element OPT1 may become 0. That is, because in embodiments the voltage level of the node NOMID5 connected to the source terminal of the first output protection switching element OPT1 becomes the second bias voltage VG2, the gate-source voltage VGS of the first output protection switching element OPT1 may become 0 so that the first input protection switching element IPT1 of some embodiments may be completely turned off.

The second output protection switching element OPT2 may be an NMOS transistor. A gate terminal of the second output protection switching element OPT2 may be connected to the second bias voltage VG2 line. Referring to FIG. 3, the gate terminal of the second output protection switching element OPT2 may be connected to a node NG22 to which the second bias voltage VG2 is applied. A source terminal of the second output protection switching element OPT2 may be connected to the node NMID6 and may be connected to the fourth input switching element IT4. A drain terminal of the second output protection switching element OPT2 may be connected to the node NOMID4 and may be connected to the fourth output protection switching element OPT4.

When the node NOMID6 is grounded at the first ground voltage VSS1 from the voltage of the drain terminal of the fourth input switching element IT4, the node NOMID3 connected to the drain terminal of the second output protection switching element OPT2 may have the first ground voltage VSS 1. Here, the second output protection switching element OPT2 is an NMOS transistor, and because in embodiments the second bias voltage VG2 that is sufficiently higher than the source voltage is applied through the gate terminal, the gate-source voltage VGS may exceed the threshold voltage so that the second output protection switching element OPT2 of embodiments is maintained in a turned-on state.

Conversely, when a voltage having the second power supply voltage VDD2 is applied from the drain terminal of the fourth output protection switching element OPT4 to the node NOMID4, the node NOMID6 connected to the source terminal of the second output protection switching element OPT2 may have the second bias voltage VG2. This is because in embodiments the voltage level of the node NOMID6 connected to the source terminal of the second output protection switching element OPT2 increases to the second bias voltage VG2 as current (or leakage current) may flow until the gate-source voltage VGS of the second output protection switching element OPT2 may become 0. That is, because in embodiments the voltage level of the node NMID6 connected to the source terminal of the second output protection switching element OPT2 becomes the second bias voltage VG2, the gate-source voltage VGS of the second output protection switching element OPT2 may become 0 so that the second output protection switching element OPT2 of some embodiments may be completely turned off.

The first output protection switching element OPT1 and the second output protection switching element OPT2 may operate complementarily. That is, when the first input protection switching element IPT1 is turned on, the second output protection switching element OPT2 may be turned off. When the first output protection switching element OPT1 is turned off, the second output protection switching element OPT2 may be turned on.

The third output protection switching element OPT3 may be a PMOS transistor. A gate terminal of the third output protection switching element OPT3 may be connected to the first bias voltage VG1 line. Referring to FIG. 3, the gate terminal of the third output protection switching element OPT3 may be connected to a node NG21 to which the first bias voltage VG1 is applied. A source terminal of the third output protection switching element OPT3 may be connected to the node NOMID1 and may be connected to the fifth output switching element OT5 of the output circuit 135. A drain terminal of the third output protection switching element OPT3 may be connected to the node NOMID3 and may be connected to the first output protection switching element OPT1.

When the node NOMID3 is grounded at the first ground voltage VSS1 from the drain terminal of the first output protection switching element OPT1, the node NOMID1 connected to the source terminal of the third output protection switching element OPT3 may have the first bias voltage VG1. This is because in embodiments the voltage level of the node NMID1 connected to the source terminal of the third output protection switching element OPT3 is lowered to the first bias voltage VG1 as current (or leakage current) may flow until the gate-source voltage VGS of the third output protection switching element OPT3 may become 0. That is, because in embodiments the voltage level of the node NOMID1 connected to the source terminal of the third output protection switching element OPT3 becomes the first bias voltage VG1, the gate-source voltage VGS of the third output protection switching element OPT3 may become 0, and thus, the third output protection switching element OPT3 of some embodiments may be completely turned off.

Conversely, when a voltage having the second power supply voltage VDD2 is applied from the drain terminal of the fifth output switching element OT5 to the node NOMID1, the node NOMID3 connected to the drain terminal of the third output protection switching element OPT3 may have the second power supply voltage VDD2. Here, the third output protection switching element OPT3 is a PMOS transistor, and because in embodiments the first bias voltage VG1 that is sufficiently lower than the source voltage is applied through the gate terminal, the source-gate voltage VSG may exceed the threshold voltage so that the third output protection switching element OPT3 of some embodiments is maintained in a turned-on state.

The fourth output protection switching element OPT4 may be a PMOS transistor. The gate terminal of the fourth output protection switching element OPT4 may be connected to the first bias voltage VG1 line. Referring to FIG. 3, a gate terminal of the fourth output protection switching element OPT4 may be connected to a node NG21 to which the first bias voltage VG1 is applied. A source terminal of the fourth output protection switching element OPT4 is connected to the node NOMID2 and may be connected to the sixth output switching element OT6 of the output circuit 135. A drain terminal of the fourth output protection switching element OPT4 may be connected to the node NOMID4 and may be connected to the second output protection switching element OPT2.

When the node NOMID4 is grounded at the first ground voltage VSS1 from the drain terminal of the second output protection switching element OPT2, the node NOMID2 connected to the source terminal of the fourth output protection switching element OPT4 may have the first bias voltage VG1. This is because in embodiments the voltage level of the node NOMID2 connected to the source terminal of the fourth output protection switching element OPT4 is lowered to the first bias voltage VG1 as current (or leakage current) may flow until the gate-source voltage VGS of the fourth output protection switching element OPT4 may become 0. That is, because in embodiments the voltage level of the node NOMID2 connected to the source terminal of the fourth output protection switching element OPT4 becomes the first bias voltage VG1, the gate-source voltage VGS of the fourth output protection switching element OPT4 may become 0, and thus, the fourth output protection switching element OPT4 of some embodiments may be completely turned off.

Conversely, when a voltage having the second power supply voltage VDD2 is applied from the drain terminal of the sixth output switching element OT6 to the node NOMID2, the node NOMID4 connected to the drain terminal of the fourth output protection switching element OPT4 may have the second power supply voltage VDD2. Here, the fourth output protection switching element OPT4 is a PMOS transistor, and because in embodiments the first bias voltage VG1 that is sufficiently lower than the source voltage is applied through the gate terminal, the source-gate voltage VSG may exceed the threshold voltage so that the fourth output protection switching element OPT4 of some embodiments is maintained in a turn-on state.

The third output protection switching element OPT3 and the fourth output protection switching element OP4 may operate complementarily. That is, when the third output protection switching element OPT3 is turned on, the fourth output protection switching element OP4 may be turned off. When the third output protection switching element OPT3 is turned off, the fourth output protection switching element OP4 may be turned on.

The first output protection switching element OPT1 and the third output protection switching element OP3 may operate complementarily. That is, when the first output protection switching element OPT1 is turned on, the third output protection switching element OP3 may be turned off. When the first output protection switching element OPT1 is turned off, the third output protection switching element OP3 may be turned on. Similarly, the second output protection switching element OPT2 and the fourth output protection switching element OP4 may also operate complementarily.

Referring to FIG. 3, the output circuit 135 may include multiple switching elements, e.g., first to sixth output switching elements OT1 to OT6.

The first output switching element OT1 may be a PMOS transistor. A gate terminal of the first output switching element OT1 may be connected to the first intermediate voltage VMID1 line. Referring to FIG. 3, the gate terminal of the first output switching element OT1 may be connected to the node NMID1. A source terminal of the first output switching element OT1 may be connected to the second power supply voltage VDD2 line. A drain terminal of the first output switching element OT1 may be connected to a drain terminal of the second output switching element OT2, a gate terminal of the sixth output switching element OT6, and the output voltage VOUT line.

The second output switching element OT2 may be an NMOS transistor. The gate terminal of the second output switching element OT2 may be connected to the first intermediate voltage VMID1 line. Referring to FIG. 3, the gate terminal of the second output switching element OT2 may be connected to the node NMID1. The drain terminal of the second output switching element OT2 may be connected to the drain terminal of the first output switching element OT1, a gate terminal of the fifth output switching element OT5, and the inverted output voltage VOUTB line. A source terminal of the second output switching element OT2 may be connected to a drain terminal of the fifth output switching element OT5.

The first and second output switching elements OT1 and OT2 may operate as inverters. Therefore, when the first intermediate voltage VMID1 having the second ground voltage VSS2 is applied to the gate terminals of the first and second output switching elements OT1 and OT2, the second power supply voltage VDD2 may be output to a gate terminal of the sixth output switching element OT6 and the output voltage VOUT line. Conversely, when the first intermediate voltage VMID1 having the second power supply voltage VDD2 is applied to the gate terminals of the first and second output switching elements OT1 and OT2, the second ground voltage VSS2 may be output to the gate terminal of the sixth output switching element OT6 and the output voltage VOUT line.

The third output switching element OT3 may be a PMOS transistor. A gate terminal of the third output switching element OT3 may be connected to the second intermediate voltage VMID2 line. Referring to FIG. 3, the gate terminal of the third output switching element OT3 may be connected to the node NMID2. A source terminal of the third output switching element OT3 may be connected to the second power supply voltage VDD2 line. A drain terminal of the third output switching element OT3 may be connected to a drain terminal of the fourth output switching element OT4, a gate terminal of the fifth output switching element OT5, and the inverted output voltage VOUTB line.

The fourth output switching element OT4 may be an NMOS transistor. A gate terminal of the fourth output switching element OT4 may be connected to the second intermediate voltage VMID2 line. Referring to FIG. 3, the gate terminal of the fourth output switching element OT4 may be connected to the node NMID2. The drain terminal of the fourth output switching element OT4 may be connected to the drain terminal of the third output switching element OT3, the gate terminal of the fifth output switching element OT5, and the inverted output voltage VOUTB line. A source terminal of the fourth output switching element OT4 may be connected to a drain terminal of the sixth output switching element OT6.

The third and fourth output switching elements OT3 and OT4 may operate as inverters. Therefore, when the second intermediate voltage VMID2 having the second ground voltage VSS2 is applied to the gate terminals of the third and fourth output switching elements OT3 and OT4, the second power supply voltage VDD2 may be output to the gate terminal of the fifth output switching element OT5. Conversely, when the second intermediate voltage VMID2 having the second power supply voltage VDD2 is applied to the gate terminals of the third and fourth output switching elements OT3 and OT4, the second ground voltage VSS2 may be output to the gate terminal of the fifth output switching element OT5.

The fifth output switching element OT5 may be an NMOS transistor. The gate terminal of the fifth output switching element OT5 may be connected to the drain terminal of the third output switching element OT3, the drain terminal of the fourth output switching element OT4, and the inverted output voltage VOUTB line. The drain terminal of the fifth output switching element OT5 may be connected to the node NO1 and may be connected to the source terminal of the second output switching element OT2. A source terminal of the fifth output switching element OT5 may be connected to the node NOMID1 and may be connected to the third output protection switching element OPT3.

The sixth output switching element OT6 may be an NMOS transistor. The gate terminal of the sixth output switching element OT6 may be connected to the drain terminal of the first output switching element OT1, the drain terminal of the second output switching element OT2, and the output voltage VOUT line. The drain terminal of the sixth output switching element OT6 may be connected to the node NO2 and may be connected to the source terminal of the fourth output switching element OT4. A source terminal of the sixth output switching element OT6 is connected to the node NOMID2 and may be connected to the fourth output protection switching element OPT4.

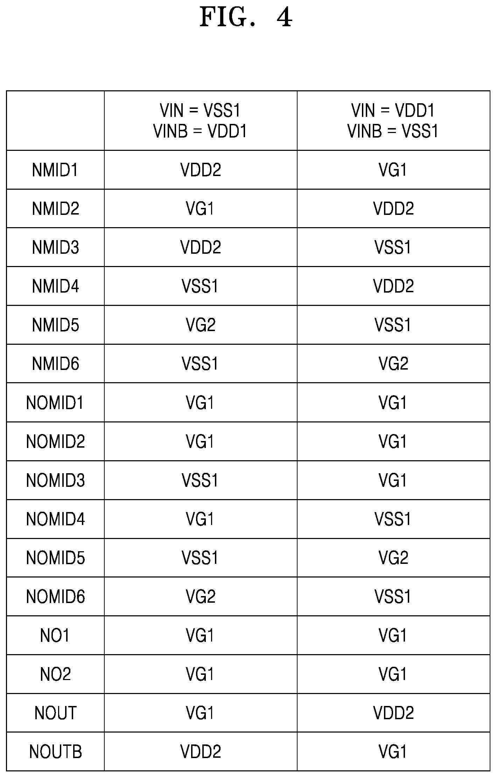

FIG. 4 is a table illustrating voltage changes according to levels of input voltages input to the level shifter 100 according to one or more embodiments.

Referring to FIG. 4, the table illustrate voltage levels of nodes NMID1 to NMID6 of the first stage circuit 120 and nodes NOMID1 to NOMID6, NOUT, and NOUTB of the second stage circuit 130 when the voltage level of the input voltage VIN is the first ground voltage VSS1, the voltage level of the inverted input voltage VINB is the first power supply voltage VDD1, the voltage level of the input voltage VIN is the first power supply voltage VDD1, and the voltage level of the inverted input voltage VINB is the first ground voltage VSS1.

First, if the voltage level of the input voltage VIN is the first ground voltage VSS1, the inverted input voltage VINB may have the first power supply voltage VDD1 by the inverting circuit 110 (or the inverter I), and if the voltage level of the input voltage VIN is the first power supply voltage VDD1, the inverted input voltage VINB may have the first ground voltage VSS1 by the inverting circuit 110 (or the inverter I).

First, a case in which the voltage level of the input voltage VIN is the first ground voltage VSS1 and the voltage level of the inverted input voltage VINB is the first power supply voltage VDD1 is described.

As the second input switching element IT2 is turned on by the inverted input voltage VINB having the first power supply voltage VDD1, the node NMID6 is connected to the first ground voltage VSS1 line through the second input switching element IT2, so that the node NMID6 may have the first ground voltage VSS1.

As the second input protection switching element IPT2 is turned on by the second bias voltage VG2, the node NMID6 is connected to the node NMID4, so that the node NMID4 may have the same level as the first ground voltage VSS1.

Although the fourth input protection switching element IPT4 is turned on by the first bias voltage VG1, current (or leakage current) may flow until the fourth input protection switching element IPT4 is completely turned off, and thus, the voltage level of the node NMID2 may in embodiments be lowered to the first bias voltage VG1 which is the same as the gate voltage level of the fourth input protection switching element IPT4. That is, the node NMID2 may have the first bias voltage VG1.

When the node NMID2 has the first bias voltage VG1, the first cross-switching element CT1 is turned on and the node NMID1 is connected to the second power supply voltage VDD2 line, so that the node NMID1 may have the second power supply voltage VDD2.

As the third input protection switching element IPT3 is turned on by the first bias voltage VG1, the node NMID1 is connected to the node NMID3, so that the node NMID3 may have the second power supply voltage VDD2, like the node NMDI1.

Although the first input switching element IT1 is turned off by the input voltage VIN having the first ground voltage VSS1 and the first input protection switching element IPT1 is turned on by the node NG12 having the second bias voltage VG2, current (or leakage current) may flow until the first input protection switching element IPT1 is completely turned off. Here, the voltage level of the node NMID5 may increase to the second bias voltage VG2 that is equal to the gate voltage level of the first input protection switching element IPT1. That is, the voltage level of the node NMID5 may have the second bias voltage VG2.

That is, when the voltage level of the input voltage VIN is the first ground voltage VSS1 and the voltage level of the inverted input voltage VINB is the first power supply voltage VDD1, the voltage level of the node NMID1 has the second power supply voltage VDD2 and the voltage level of the node MID2 has the first bias voltage VG1, and thus, the first intermediate voltage VMID1 may have the second power supply voltage VDD2 and the second intermediate voltage VMID2 may have the first bias voltage VG1.

As the third input switching element IT3 is turned on by the inverted input voltage VINB having the first power supply voltage VDD1, the node NOMID5 is connected to the first ground voltage VSS1 line through the third input switching element IT3, so that the node NOMID5 may have the first ground voltage VSS1.

As the first output protection switching element OPT1 is turned on by the second bias voltage VG2, the node NOMID3 is connected to the node NOMID5, so that the node NOMID3 may have the first ground voltage VSS1, like the node NOMID5.

Although the third output protection switching element OPT3 is turned on by the first bias voltage VG1, current (or leakage current) may flow until the third output protection switching element OPT3 is completely turned off, so that the voltage level of the node NOMID1 may be lowered to the first bias voltage VG1 that is the same as the gate voltage level of the third output protection switching element OPT3. That is, the node NOMID1 may have the first bias voltage VG1.

As the third output switching element OT3 is turned on by the second intermediate voltage VMID2 having the first bias voltage VG1, the node NOUTB is connected to the second power supply voltage VDD2 line, so that the node NOUTB may have the second power supply voltage VDD2.

In embodiments, because the voltage level of the node NOUTB is the level of the second power supply voltage VDD2 and the node NOMID1 is connected to the node NO1 as the fifth output switching element OT5 is turned on, the node NO1 may have the first bias voltage VG1, like the node NOMIDI1.

As the second output switching element OT2 is turned on by the first intermediate voltage VMID1 having the second power supply voltage VDD2, the node NO1 is connected to the node NOUT, so that the node NOUT may have the first bias voltage VG1, like the node NO1.

Although the fourth output switching element OT4 is turned on by the second intermediate voltage VMID2 having the first bias voltage VG1, current (or leakage current) may flow until the fourth output switching element OT4 is completely turned off, so that the voltage level of the node NO2 may rise to the first bias voltage VG1 which is the same as the gate voltage level of the fourth output switching element OT4. That is, the node NO2 may have the first bias voltage VG1.

Although the sixth output switching element OT6 is turned on by the node NOUT having the first bias voltage VG1, current (or leakage current) may flow until the sixth output switching element OT6 is completely turned off, so that the voltage level of the node NOMID2 may rise to the first bias voltage VG1 which is the same as the gate voltage level of the sixth output switching element OT6. That is, the node NOMID2 may have the first bias voltage VG1.

Although the fourth output protection switching element OPT4 is turned on by the node NG21 having the first bias voltage VG1, current (or leakage current) may flow until the fourth output protection switching element OPT4 is completely turned off, so that the voltage level of the node NOMID4 may rise to the first bias voltage VG1 which is the same as the voltage level of the node NOMID2. That is, the node NOMID4 may have the first bias voltage VG1.

Although the second output protection switching element OPT2 is turned on by the node NG22 having the second bias voltage VG2, current (or leakage current) may flow until the second output protection switching element OPT2 is completely turned off, so that the voltage level of the node NOMID6 may rise to the second bias voltage VG2 which is the same as the gate voltage level of the second output protection switching element OPT2. That is, the voltage level of the node NOMID6 may have the second bias voltage VG2.

That is, when the voltage level of the input voltage VIN is the first ground voltage VSS1 and the voltage level of the inverted input voltage VINB is the first power supply voltage VDD1, node NOUT has the first bias voltage VG1 and the node NOUTB has the second power supply voltage VDD2, and thus, the output voltage VOUT may have the first bias voltage VG1 and the inverted output voltage VOUTB may have the second power supply voltage VDD2.

Hereinafter, a case in which the voltage level of the input voltage VIN is the first power supply voltage VDD1 and the voltage level of the inverted input voltage VINB is the first ground voltage VSS1 is described.

As the first input switching element IT1 is turned on by the input voltage VIN having the first power supply voltage VDD1, the node NMID5 is connected to the first ground voltage VSS1 line through the first input switching element IT1, so that the node NMID5 may have the first ground voltage VSS1.

As the first input protection switching element IPT1 is turned on by the second bias voltage VG2, the node NMID5 is connected to the node NMID3, so that the node NMID3 may have the first ground voltage VSS1, like the node NMID5.

Although the third input protection switching element IPT3 is turned on by the first bias voltage VG1, current (or leakage current) may flow until the third input protection switching element IPT3 is completely turned off, and thus, the voltage level of the node NMID1 may be lowered to the first bias voltage VG1 which is the same as the gate voltage level of the third input protection switching element IPT3. That is, the node NMID1 may have the first bias voltage VG1.

When the voltage level of the node NMID1 has the first bias voltage VG1, the second cross-switching element CT2 is turned on and the node NMID2 may be connected to the second power supply voltage VDD2 line, so that the node NMID2 may have the second power supply voltage VDD2.

As the fourth input protection switching element IPT4 is turned on by the first bias voltage VG1, the node NMID2 is connected to the node NMID4, so that the node NMID4 may have the second power supply voltage VDD2, like the node NMID2.

Although the second input switching element IT2 is turned off by the inverted input voltage VINB having the first ground voltage VSS1 and the second input protection switching element IPT2 is turned on by the node NG12 having the second bias voltage VG2, current (or leakage current) may flow until the second input protection switching element IPT2 is completely turned off. Here, the voltage level of the node NMID6 may increase to the second bias voltage VG2 that is equal to the gate voltage level of the second input protection switching element IPT2. That is, the node NMID6 may have the second bias voltage VG2.

That is, when the voltage level of the input voltage VIN is the first power supply voltage VDD1 and the voltage level of the inverted input voltage VINB is the first ground voltage VSS1, the voltage level of the node NMID1 has the first bias voltage VG1 and the voltage level of the node MID2 has the second power supply voltage VDD2, and thus, the first intermediate voltage VMID1 may have the first bias voltage VG1 and the second intermediate voltage VMID2 may have the second power supply voltage VDD2.

As the fourth input switching element IT4 is turned on by the input voltage VIN having the first power supply voltage VDD1, the node NOMID6 is connected to the first ground voltage VSS1 line through the fourth input switching element IT4, so that the voltage level of the node NOMID6 may have the first ground voltage VSS1.

As the second output protection switching element OPT2 is turned on by the second bias voltage VG2, the node NOMID6 is connected to the node NOMID4, so that the node NOMID4 may have the first ground voltage VSS1, like the node NOMID6.

Although the fourth output protection switching element OPT4 is turned on by the first bias voltage VG1, current (or leakage current) may flow until the fourth output protection switching element OPT4 is completely turned off, and thus, the voltage level of the node NOMID2 may be lowered to the first bias voltage VG1 that is the same as the gate voltage level of the fourth output protection switching element OPT4. That is, the node NOMID2 may have the first bias voltage VG1.

As the first output switching element OT1 is turned on by the first intermediate voltage VMID1 having the first bias voltage VG1, the node NOUT is connected to the second power supply voltage VDD2 line, so that the node NOUT may have the second power supply voltage VDD2.

In embodiments, because the voltage level of the node NOUT is the level of the second power supply voltage VDD2, the node NOMID2 is connected to the node NO2 as the sixth output switching element OT6 is turned on, the node NO2 may have the first bias voltage VG1, like the node NOMID2.

As the fourth output switching element OT4 is turned on by the second intermediate voltage VMID2 having the second power supply voltage VDD2, the node NO2 is connected to the node NOUTB, so that the node NOUTB may have the first bias voltage VG1, like the node NO2.

Although the second output switching element OT2 is turned on by the first intermediate voltage VMID1 having the first bias voltage VG1, current (or leakage current) may flow until the second output switching element OT2 is completely turned off, so that the voltage level of the node NO1 may rise to the first bias voltage VG1 which is the same as the gate voltage level of the second output switching element OT2. That is, the node NO1 may have the first bias voltage VG1.

Although the fifth output switching element OT5 is turned on by the node NOUTB having the first bias voltage VG1, current (or leakage current) may flow until the second output switching element OT2 is completely turned off, so that the voltage level of the node NOMID1 may rise to the first bias voltage VG1 which is the same as the gate voltage level of the fifth output switching element OT5. That is, the node NOMID1 may have the first bias voltage VG1.

Although the third output protection switching element OPT3 is turned on by the node NG21 having the first bias voltage VG1, current (or leakage current) may flow until the third output protection switching element OPT3 is completely turned off, so that the voltage level of the node NOMID3 may rise to the first bias voltage VG1 which is the same as the voltage level of the node NOMID1. That is, the node NOMID3 may have the first bias voltage VG1.

Although the first output protection switching element OPT1 is turned on by the node NG22 having the second bias voltage VG2, current (or leakage current) may flow until the first output protection switching element OPT1 is completely turned off, so that the voltage level of the node NOMID5 may rise to the second bias voltage VG2 which is the same as the gate voltage level of the first output protection switching element OPT1. That is, the node NOMID5 may have the second bias voltage VG2.

That is, when the voltage level of the input voltage VIN is the first power supply voltage VDD1 and the voltage level of the inverted input voltage VINB is the first ground voltage VSS1, the node NOUT has the second power supply voltage VDD2 and the node NOUTB has the first bias voltage VG1, and thus, the output voltage VOUT may have the second power supply voltage VDD2 and the inverted output voltage VOUTB may have the first bias voltage VG1.

As described above, when the voltage level of the input voltage VIN is the first ground voltage VSS1 and the voltage level of the inverted input voltage VINB is the first power supply voltage VDD1, the output protection circuit 133 may adjust the voltage of the output voltage VOUT to the first bias voltage VG1. The output circuit 135 may adjust the voltage level of the inverted output voltage VOUTB to the second power supply voltage VDD2.

As described above, when the voltage level of the input voltage VIN is the first power supply voltage VDD1 and the voltage level of the inverted input voltage VINB is the first ground voltage VSS1, the output protection circuit 133 may adjust the voltage level of the output voltage VOUT to the second power supply voltage VDD2. The output protection circuit 133 may adjust the voltage level of the inverted output voltage VOUTB to the first bias voltage VG1.

Referring to FIGS. 3 and 4, the maximum value of the voltage level of the nodes NMID5 and NMID6 to which the first input circuit 121 and the input protection circuit 123 are connected may be the second bias voltage VG2, and the minimum value of the voltage level of the nodes NMID1 and NMID2 to which the cross-coupled circuit 125 and the input protection circuit 123 are connected may be the first bias voltage VG1.

That is, in embodiments, because the first stage circuit 120 includes the input protection circuit 123 including a plurality of input protection switching elements, overvoltage may be reduced or prevented in the switching elements included in the first stage circuit 120.

Referring to FIGS. 3 and 4, the maximum value of the voltage level of the nodes NOMID5 and NOMID6 to which the second input circuit 131 and the output protection circuit 133 are connected may be the second bias voltage VG2, and the minimum value of the voltage level of the nodes NOMID1 and NOMID2 to which the output circuit 135 and the output protection circuit 133 are connected may be the first bias voltage VG1.

That is, in embodiments, because the second stage circuit 130 includes the output protection circuit 133 including a plurality of output protection switching elements, overvoltage may be reduced or prevented in the switching elements included in the second stage circuit 130.

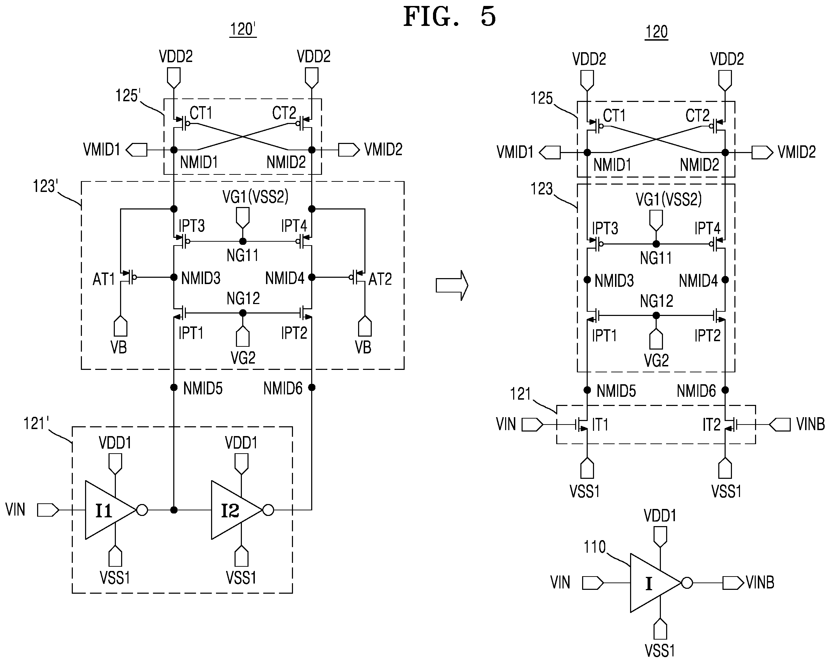

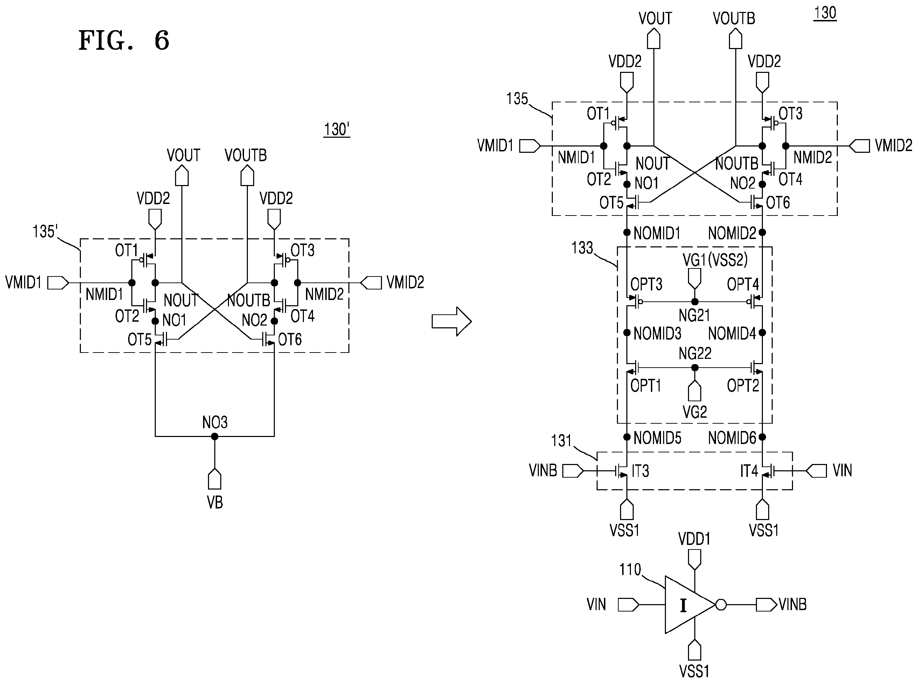

FIGS. 5 and 6 are diagrams illustrating a comparison between an embodiment and a comparative example.

FIG. 5 illustrates a first stage circuit 120' according to the comparative example and the inverting circuit 110 and the first stage circuit 120 proposed in this document. FIG. 6 illustrates a second stage circuit 130' according to the comparative example and the inverting circuit 110 and the second stage circuit 130 proposed in this document.

Referring to FIGS. 5 and 6, according to one or more embodiments, the first stage circuit 120 and the second stage circuit 130 may include the input circuits 121 and 131, respectively, but in the comparative example, only the first stage circuit 120' includes an input circuit 121'.

Referring to FIG. 5, the first power supply voltage VDD1 line connected to inverters I1 and I2 of the input circuit 121' and the second power supply voltage VDD2 line connected to a cross-coupled circuit 125' may be connected during operation. Here, unwanted current may flow between the first power supply voltage VDD1 line and the second power supply voltage VDD2 line, resulting in unnecessary power consumption.

In comparison, referring to FIGS. 5 and 6, the input voltage VIN line and the inverted input voltage VINB line are connected to the gate terminals of the input switching elements IT1, IT2, IT3, and IT4 included in the input circuits 121 and 131, so that the first power supply voltage VDD1 line connected to the inverting circuit 110 and the second power supply voltage VDD2 line connected to the cross-coupled circuit 125 are not connected during operation. Therefore, in embodiments, because a current path is not formed between the first power supply voltage VDD1 line and the second power supply voltage VDD2 line, unnecessary power consumption may be avoided.

Referring to FIGS. 5 and 6, in order to limit a swing range of the output voltage VOUT and the inverted output voltage VOUTB to between the second ground voltage VSS2 and the second power supply voltage VDD2, the first stage circuit 120' and the second stage circuit 130' have to form a current path with a bias voltage VB line of a bias voltage generating circuit 140' of FIG. 7.

For example, the node NMID1 and the node NMID2 of an input protection circuit 123' may be connected to a bias voltage VB line that is the same as the first bias voltage VG1, and a node NO3 of an output circuit 135' may be connected to the bias voltage VB line that is the same as the first bias voltage VG1. Here, the bias voltage VB may be generated by the bias voltage generating circuit 140' of FIG. 7.

That is, in order for the first stage circuit 120' and the second stage circuit 130' to operate, a current path has to be formed between the bias voltage generating circuit 140' and the first stage circuit 120' and a current path has to be formed between the bias voltage generating circuit 140' and the second stage circuit 130'. Because the bias voltage generating circuit 140' of FIG. 7 has to provide the bias voltage VB for current to passes in this manner, current consumption of the bias voltage generating circuit 140' of FIG. 7 may increase.

Referring to FIGS. 5 and 6, in order to limit the swing range of the output voltage VOUT and the inverted output voltage VOUTB to between the second ground voltage VSS2 and the second power supply voltage VDD2, the first stage circuit 120 and the second stage circuit 130 may in some embodiments not form a current path with the bias voltage VB of the bias voltage generating circuit 140 of FIG. 7.

Instead, because in embodiments the second stage circuit 130 further includes the second input circuit 131 and the output protection circuit 133, in one or more embodiments, the swing range of the output voltage VOUT and the inverted output voltage VOUTB may be limited to between the second ground voltage VSS2 and the second power supply voltage VDD2 without the bias voltage VB.

That is, the input protection circuit 123 and the output circuit 135 may not be connected to the bias voltage VB line, and the first stage circuit 120 and the second stage circuit 130 may limit the swing range of the output voltage VOUT and the inverted output voltage VOUTB to between the second ground voltage VSS2 and the second power supply voltage VDD2. Accordingly, the bias voltage generating circuit 140 of FIG. 7 may not generate the bias voltage VB. In embodiments, because the bias voltage generating circuit 140 of FIG. 7 provides the bias voltages VG1 and VG2 to the gate terminals of the switching elements IPT1 to IPT4 of the input protection circuit 123 and the gate terminals of the switching elements OPT1 to OPT4 of the output protection circuit 133 without generating the bias voltage VB, the bias voltage generating circuit 140 of FIG. 7 may significantly reduce current consumption.

FIG. 7 is a block diagram illustrating the bias voltage generating circuit 140 of the level shifter 1 according to an embodiment and a bias voltage generating circuit 140' according to the comparative example.

Referring to FIG. 7, the bias voltage generating circuit 140 of embodiments and the bias voltage generating circuit 140' according to the comparative example may be confirmed.

The bias voltage generating circuit 140 may be connected between the second power supply voltage VDD2 line and the first ground voltage VSS1 line. The bias voltage generating circuit 140 may generate the first bias voltage VG1 and the second bias voltage VG2 based on the second power supply voltage VDD2 and the first ground voltage VSS1. The bias voltage generating circuit 140' according to the comparative example generates the bias voltage VB, but the bias voltage generating circuit 140 of embodiments may not generate the bias voltage VB.

The bias voltage generating circuit 140 may output the first bias voltage VG1 to the gate terminal of the third input protection switching element IPT3 and the gate terminal of the fourth input protection switching element IPT4. The bias voltage generating circuit 140 may output the first bias voltage VG1 to the gate terminal of the third output protection switching element OPT3 and the gate terminal of the fourth output protection switching element OPT4.

The bias voltage generating circuit 140 may output the second bias voltage VG2 to the gate terminal of the first input protection switching element PT1 and the gate terminal of the second input protection switching element PT2. The bias voltage generating circuit 140 may output the second bias voltage VG2 to the gate terminal of the first output protection switching element OPT1 and the gate terminal of the second output protection switching element OPT2.

Compared to the bias voltage generating circuit 140' according to the comparative example, the bias voltage generating circuit 140 according to one or more embodiments provides the bias voltages VG1 and VG2 to the gate terminals of the switching elements IPT1 to IPT4 of the input protection circuit 123 and the gate terminals of the switching elements OPT1 to OPT4 of the output protection circuit 133 without generating the bias voltage VB, and thus, the bias voltage generating circuit 140 may significantly reduce current consumption.

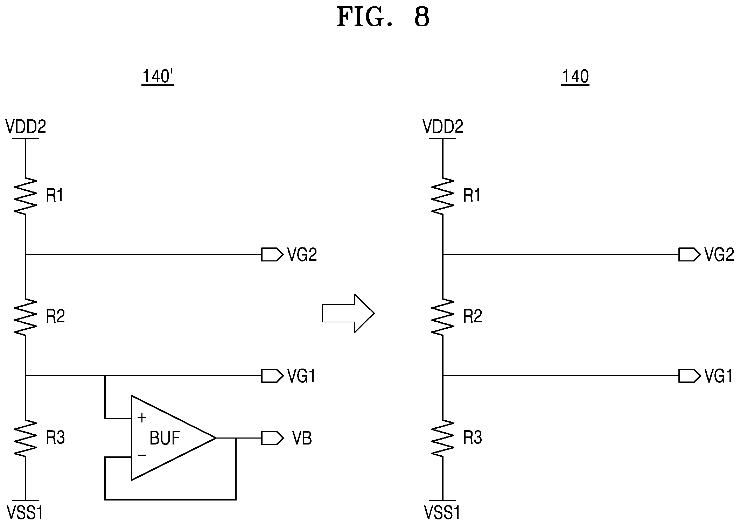

FIG. 8 is a circuit diagram illustrating an example of the bias voltage generating circuit 140 according to an embodiment and an example of the bias voltage generating circuit 140' according to the comparative example.

Referring to FIG. 8, an example of a circuit diagram of the bias voltage generating circuit 140 of embodiments and an example of a circuit diagram of the bias voltage generating circuit 140' according to the comparative example may be identified.

For example, the second power supply voltage VDD2 may be 1.2 V, the first ground voltage VSS1 may be 0 V, the second bias voltage VG2 may be 0.7 V, and the first bias voltage VG1 may be 0.5 V.

Referring to FIG. 8, the bias voltage generating circuit 140' may include first to third resistors R1 to R3 and a buffer BUF. The first to third resistors R1 to R3 may be connected in series between the second power supply voltage VDD2 line and the first ground voltage VSS1 line.

In one or more embodiments, one end of the first resistor R1 may be connected to the second power supply voltage VDD2 line. One end of the second resistor R2 may be connected to the other end of the first resistor R1. One end of the third resistor R3 may be connected to the other end of the second resistor R2. The other end of the third resistor R3 may be connected to the first ground voltage VSS1 line. The bias voltage generating circuit 140' may output the second bias voltage VG2 through a terminal between the first resistor R1 and the second resistor R2. In addition, the bias voltage generating circuit 140' may output the first bias voltage VG1 through a terminal between the second resistor R2 and the third resistor R3.

In the buffer BUF, a positive input terminal (+) may be connected to the terminal between the second resistor R2 and the third resistor R3. In the buffer BUF, a negative input terminal (-) may be connected to an output terminal. The bias voltage generating circuit 140' may output the bias voltage VB through the output terminal of the buffer BUF. Here, the bias voltage VB may have the same voltage level as that of the first bias voltage VG1. In this manner, in the comparative example, by outputting the bias voltage VB through the buffer BUF, current may be hindered or prevented from flowing backward from the source terminals and/or the drain terminals of the switching elements of the comparative example.

In contrast, the bias voltage generating circuit 140 of embodiments may not include the buffer BUF. In one or more embodiments, the swing range of the output voltage VOUT and the inverted output voltage VOUTB may be limited to between the second ground voltage VSS2 and the second power supply voltage VDD2 without the buffer BUF that outputs the bias voltage VB. That is, the bias voltage generating circuit 140 may provide the first bias voltage VG1 to the first stage circuit 120 and the second stage circuit 130 without buffering the first bias voltage VG1 (i.e., without providing the additional bias voltage VB).

Because the bias voltage generating circuit 140 of embodiments does not include the buffer BUF that outputs the bias voltage VB, current of several microamperes (uA) to several tens of microamperes (uA) may in some embodiments not have to flow between the second power supply voltage VDD2 line and the first ground voltage VSS1 line required to drive the buffer BUF.

That is, in embodiments, because the first bias voltage VG1 and the second bias voltage VG2 are output without outputting the bias voltage VB, in the bias voltage generating circuit 140, a flow of current less than several microamperes (uA) between the second power supply voltage VDD2 line and the first ground voltage VSS1 line may be sufficient. Accordingly, in some embodiments the bias voltage generating circuit 140 may significantly reduce current consumption.

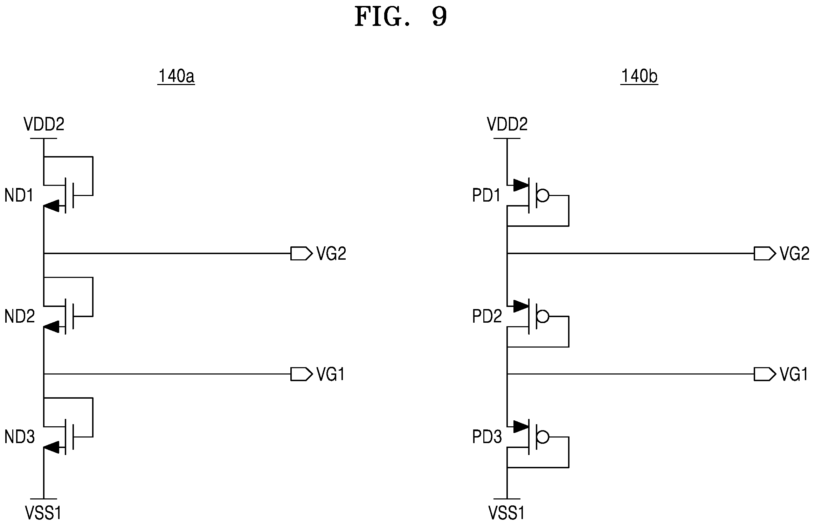

FIG. 9 is a circuit diagram illustrating other examples of the bias voltage generating circuit 140 according to one or more embodiments.

Active resistance may be implemented by diode-connected transistors having better area efficiency than resistors in integrated circuits (ICs).

Referring to FIG. 9, the bias voltage generating circuit 140 of embodiments may be implemented with an NMOS diode-connected transistor and/or a PMOS diode-connected transistor.

Referring to FIG. 9, a bias voltage generating circuit 140a may include multiple NMOS diode-connected transistors such as first to third NMOS diode-connected transistors ND1, ND2 and ND3. The e.g. first to third NMOS diode-connected transistors ND1, ND2, and ND3 may be connected in series between the second power supply voltage VDD2 line and the first ground voltage VSS1 line.

The bias voltage generating circuit 140a may output the second bias voltage VG2 through a terminal between the first NMOS diode-connected transistor ND1 and the second NMOS diode-connected transistor ND2. The bias voltage generating circuit 140a may output the first bias voltage VG1 through a terminal between the second NMOS diode-connected transistor ND2 and the third NMOS diode-connected transistor ND3.

Referring to FIG. 9, a bias voltage generating circuit 140b may include multiple PMOS diode-connected transistors such as first to third PMOS diode-connected transistors PD1, PD2, and PD3. The e.g. first to third PMOS diode-connected transistors PD1, PD2, and PD3 may be connected in series between the second power supply voltage VDD2 line and the first ground voltage VSS1 line.

The bias voltage generating circuit 140b may output the second bias voltage VG2 through a terminal between a first PMOS diode-connected transistor PD1 and a second PMOS diode-connected transistor PD2. The bias voltage generating circuit 140b may output the first bias voltage VG1 through a terminal between the second PMOS diode-connected transistor PD2 and the third PMOS diode-connected transistor PD3.

However, the bias voltage generating circuit 140 of embodiments is not limited to the bias voltage generating circuit 140a and the bias voltage generating circuit 140b, and the bias voltage generating circuit 140 of embodimentsmay be implemented by combining NMOS diode-connected transistors and/or PMOS diode-connected transistors in various manners.

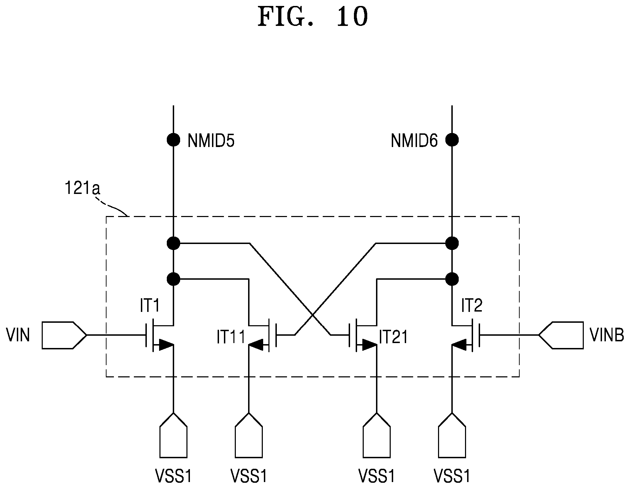

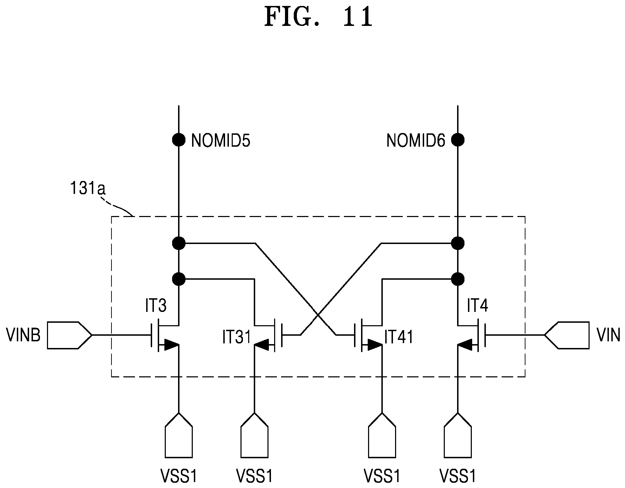

FIG. 10 is a circuit diagram illustrating another example of a first input circuit 121a according to one or more embodiments. FIG. 11 is a circuit diagram illustrating another example of a second input circuit 131a according to one or more embodiments.

Differences between the first input circuit 121 and a first input circuit 121a and differences between the second input circuit 131 and a second input circuit 131a are mainly described.

Referring to FIG. 10, the first input circuit 121a may further include preferably both of an input switching element IT11 and an input switching element IT21.

A gate terminal of the input switching element IT11 may be connected to the node NMID6. A source terminal of the input switching element IT11 may be connected to the first ground voltage VSS1 line. A drain terminal of the input switching element IT11 may be connected to the node NMID5.

A gate terminal of the input switching element IT21 may be connected to the node NMID5. A source terminal of the input switching element IT21 may be connected to the first ground voltage VSS1 line. A drain terminal of the input switching element IT21 may be connected to the node NMID6.

That is, the input switching element IT11 and the input switching element IT21 may provide feedback paths to the node NMID5 and the node NMID6, respectively. By providing the feedback paths to the nodes NMID5 and NMID6, a change in voltage level may be amplified and rapidly transitioned to a stable state. Because in embodiments a change in voltage level of one node affects the voltage level of another node, even a small change in voltage level may have a significant effect and a change in voltage level may be amplified.

Referring to FIG. 11, the second input circuit 131a may further include preferably both of an input switching element IT31 and an input switching element IT41.

A gate terminal of the input switching element IT31 may be connected to the node NOMID6. A source terminal of the input switching element IT31 may be connected to the first ground voltage VSS1 line. A drain terminal of the input switching element IT31 may be connected to the node NOMID5.

A gate terminal of the input switching element IT41 may be connected to the node NOMID5. A source terminal of the input switching element IT41 may be connected to the first ground voltage VSS1 line. A drain terminal of the input switching element IT41 may be connected to the node NOMID6.

That is, the input switching element IT31 and the input switching element IT41 may provide feedback paths to the node NOMID5 and the node NOMID6, respectively. By providing the feedback paths to the nodes NOMID5 and NOMID6, a change in voltage level may be amplified and rapidly transitioned to a stable state. Because in embodiments a change in voltage level of one node affects the voltage level of another node, even a small change in voltage level may have a significant effect and a change in voltage level may be amplified.

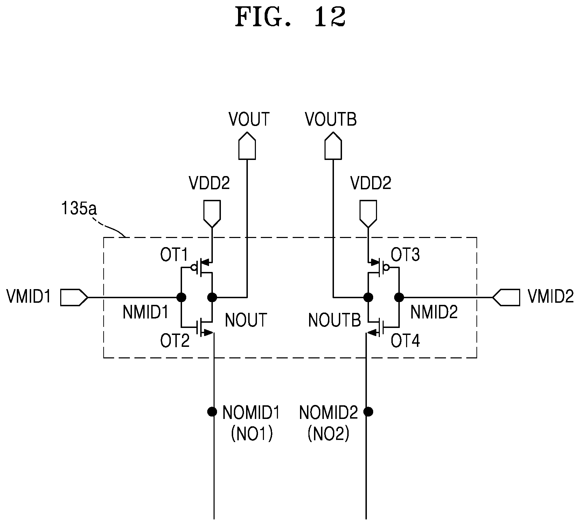

FIG. 12 is a circuit diagram illustrating another example of an output circuit 135a according to one or more embodiments.

Differences between the output circuit 135 and the output circuit 135a are mainly described.

For area efficiency of the integrated circuit (IC), the output circuit 135a may not include the fifth output switching element OT5 and the sixth output switching element OT6.

Like the output circuit 135, the first and second output switching elements OT1 and OT2 may operate as inverters. Like the output circuit 135, the third and fourth output switching elements OT3 and OT4 may operate as inverters.

The output circuit 135a may invert the first intermediate voltage VMID1 to output the output voltage VOUT. The output circuit 135a may invert the second intermediate voltage VMID2 to output the inverted output voltage VOUTB.

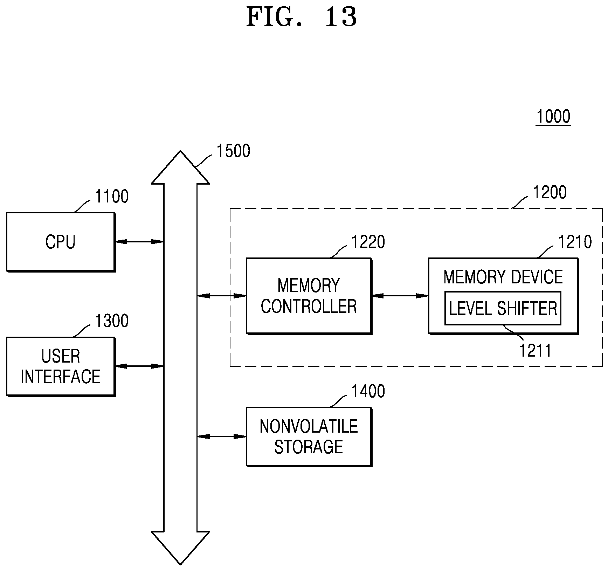

FIG. 13 is a block diagram of a computing system 1000 according to one or more embodiments.

Referring to FIG. 13, the computing system 1000 may include a central processing unit (CPU) 1100, a memory system 1200, a user interface 1300, and/or a nonvolatile storage 1400. The CPU 1100, the memory system 1200, the user interface 1300, and/or the nonvolatile storage 1400 may communicate with each other through a bus 1500. The computing system 1000 may further include ports for communicating with a video card, a sound card, a memory card, a USB device, and/or other electronic devices. The computing system 1000 may be implemented as a personal computer or a server or may be implemented as a portable electronic device, such as a laptop computer, a mobile phone, a personal digital assistant (PDA), and a camera. In case that the computing system 1000 according to one or more embodiments is a mobile device, a modem, such as a battery and a baseband chipset for supplying an operating voltage of the computing system, may be additionally provided. The computing system 1000 of embodiments may further include an application chipset, a camera image processor (CIS), and/or a mobile DRAM.

The CPU 1100 may perform calculations or tasks. According to one or more embodiments, the processor 1100 may be a microprocessor or a graphics processing unit (GPU). The CPU 1100 may communicate with the memory system 1200, the user interface 1300, and/or the nonvolatile storage 1400 through the bus 1500. The CPU 1100 may also be connected to an expansion bus, such as a peripheral component interconnect (PCI) bus.

The memory system 1200 may include a memory device 1210 and a memory controller 1220 and may store data necessary for the operation of the computing system 1000. For example, the memory system 1200 may function as a data memory of the CPU 1100 and may store data received from the bus 1500 or transmit stored data to the bus 1500 by supporting direct memory access (DMA), etc.

The memory device 1210 may include a level shifter 1211. Here, the level shifter 1211 of FIG. 13 may correspond to one of the embodiments described above. That is, the level shifter 1211 may be a level shifter according to the embodiment described above.

The level shifter 1211 may change a voltage level of a voltage applied from a power supply device (or an external device) and apply a voltage having the changed voltage level to the memory device 1210. However, the level shifter 1211 may additionally or alternatively output the voltage having the changed voltage level to a device other than the memory device 1210. In the case of FIG. 13, the level shifter 1211 and the memory controller 1220 are illustrated separately, but the memory controller 1220 may include the level shifter 1211, or the level shifter 1211 may be provided as a separate device.

The user interface 1300 may include input units, such as a keyboard, keypad, mouse, etc. to receive input signals from a user and may include output units, such as a printer, display device, etc. to provide output signals to the user.

The nonvolatile storage 1400 may include a nonvolatile semiconductor memory device, such as electrically erasable programmable read-only memory (EEPROM), flash memory, phase change random access memory (PRAM), resistance random access memory (RRAM), nano-floating gate memory (NFGM), polymer random access memory (PoRAM), magnetic random access memory (MRAM), ferroelectric random access memory (FRAM), and the like, and may also include a magnetic disk, etc.

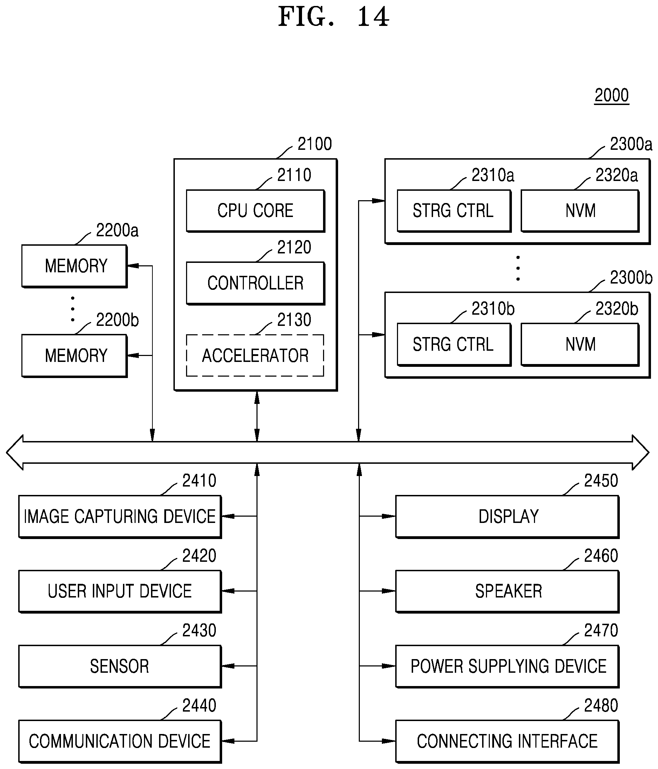

FIG. 14 is a diagram illustrating a system 2000 to which a storage device according to one or more embodiments is applied.

Referring to FIG. 14, the system 2000 of FIG. 14 may basically be a mobile system, such as a mobile phone, a smartphone, a tablet personal computer, a wearable device, a healthcare device, or an Internet of Things (IoT) device. However, the system 2000 of FIG. 11 is not necessarily limited to a mobile system but may additionally or alternatively be a personal computer, a laptop computer, a server, a media player, and/or an automotive device, such as a navigation system.

Referring to FIG. 14, the system 2000 may include a main processor 2100, memories 2200a and 2200b, and/or storage devices 2300a and 2300b and may additionally include one or more of an image capturing device 2410, a user input device 2420, a sensor 2430, a communication device 2440, a display 2450, a speaker 2460, a power supplying device 2470, and a connecting interface 2480.

The main processor 2100 may control the overall operation of the system 2000, for example, the operation of other components constituting the system 2000. Such a main processor 2100 may be implemented as a general-purpose processor, a dedicated processor, or an application processor.

The main processor 2100 may include one or more CPU cores 2110 and may further include a controller 2120 for controlling the memories 2200a and 2200b and/or the storage devices 2300a and 2300b. According to one or more embodiments, the main processor 2100 may further include an accelerator 2130, which is a dedicated circuit for high-speed data operations, such as artificial intelligence (AI) data operations. The accelerator 2130 may include a graphics processing unit (GPU), a neural processing unit (NPU), and/or a data processing unit (DPU) and may be implemented as a separate chip that is physically independent from other components of the main processor 2100.

The memories 2200a and 2200b may be used as main memory devices of the system 2000 and may include volatile memory, such as SRAM and/or DRAM, but may also include nonvolatile memory, such as flash memory, PRAM and/or RRAM. The memories 2200a and 2200b may also be implemented within the same package as that of the main processor 2100.

According to one or more embodiments, the memories 2200a and 2200b may correspond to the memory device 1210 of FIG. 13 and may include the level shifters 1 and 100 according to one or more embodiments.

According to one or more embodiments, the storage devices 2300a and 2300b may include the level shifters 1 and 100 according to one or more embodiments. Here, the level shifters 1 and 100 may change a voltage level of an input voltage applied from a power supply device or an external source, and the storage devices 2300a and 2300b may perform an operation based on the voltage having the changed voltage level. However, the level shifters 1 and 100 may also output the voltage having the changed voltage level to a device other than the storage devices 2300a and 2300b.

The storage devices 2300a and 2300b may function as nonvolatile storage devices that store data regardless of whether power is supplied and may have a relatively high storage capacity compared to the memories 2200a and 2200b. The storage devices 2300a and 2300b may include storage controllers 2310a and 2310b and nonvolatile memories (NVMs) 2320a and 2320b that store data under control by the storage controllers 2310a and 2310b. The nonvolatile memories 2320a and 2320b may include flash memory of a 2-dimensional (2D) structure or a 3-dimensional (3D) vertical NAND (V-NAND) structure but may also include other types of nonvolatile memory, such as PRAM and/or RRAM.

The storage devices 2300a and 2300b may be included in the system 2000 and physically separated from the main processor 2100 or may be implemented within the same package as the main processor 2100. The storage devices 2300a and 2300b may have a form, such as a solid state device (SSD) or a memory card and may be detachably coupled to other components of the system 2000 through an interface, such as the connecting interface 2480 to be described below. The storage devices 2300a and 2300b may be devices to which standard specifications, such as universal flash storage (UFS), embedded multimedia card (eMMC) or nonvolatile memory express (NVMe) are applied, but are not necessarily limited thereto.

The image capturing device 2410 may capture still images or moving images and may be a camera, a camcorder, and/or a webcam.

The user input device 2420 may receive various types of data input from a user of the system 2000, and may include a touch pad, a keypad, a keyboard, a mouse, and/or a microphone.

The sensor 2430 may detect various types of physical quantities that may be obtained from the outside of the system 2000 and convert the detected physical quantities into electrical signals. The sensor 2430 may include a temperature sensor, a pressure sensor, a light sensor, a position sensor, an acceleration sensor, a biosensor, and/or a gyroscope sensor.

The communication device 2440 may transmit and receive signals between other devices outside the system 2000 according to various communication protocols. The communication device 2440 may be implemented including an antenna, a transceiver, and/or a modem.

The display 2450 and the speaker 2460 may function as output devices that output visual information and auditory information, respectively, to the user of the system 2000.

The power supplying device 2470 may appropriately convert power supplied from a battery built into the system 2000 and/or an external power source and supply the same to each component of the system 2000.

The connecting interface 2480 may provide a connection between the system 2000 and an external device that is connected to the system 2000 and may exchange data with the system 2000. The connecting interface 2480 may be implemented according to various interface methods, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, universal serial bus (USB), secure digital (SD) card, multimedia card (MMC), eMMC, UFS, embedded universal flash storage (eUFS), compact flash (CF) card interface, etc.

For further assistance, it is noted that, in some comparative level shifter arrangements, a current path may be formed between a voltage generated to limit a level shifting operation and swing range of the level shifter. A voltage source for the level shifter to operate may have to maintain a fixed voltage even when a momentary current occurs, and thus, if the voltage is generated with a small current, the operation of such a level shifter may be problematic. A level shifter of an embodiment may however operate stably even with a voltage generated with a small current because a current path is not formed between a voltage source and the level shifter and the voltage is received only by a gate of a transistor.

Embodiments are set out in the following clauses:
Clause 1: A level shifter comprising:
   an inverting circuit configured to invert an input voltage that swings between a first ground voltage and a first power supply voltage and to output an inverted input voltage;
   a level shifting stage circuit configured to output a first intermediate voltage and a second intermediate voltage, based on the input voltage and the inverted input voltage; and
   a buffer stage circuit configured to invert the first intermediate voltage and the second intermediate voltage, and to output an output voltage and an inverted output voltage, wherein the output voltage and the inverted output voltage swing between a first bias voltage and a second power supply voltage,
   wherein the level shifting stage circuit comprises an input protection circuit comprising a plurality of input protection switching elements each comprising a gate terminal connected to a first bias voltage line or a second bias voltage line, and
   wherein the buffer stage circuit comprises an output protection circuit comprising a plurality of output protection switching elements each comprising a gate terminal connected to the first bias voltage line or the second bias voltage line.
Clause 2: The level shifter of clause **1,** wherein the level shifting stage circuit further comprises a first input circuit configured to connect or disconnect one end of a first intermediate path comprising a node that outputs the first intermediate voltage from a first ground voltage line, and to connect or disconnect one end of a second intermediate path comprising a node that outputs the second intermediate voltage from the first ground voltage line.
Clause 3: The level shifter of clause 2,
   wherein an input terminal of the inverting circuit is connected to an input voltage line,
   wherein a power terminal of the inverting circuit is connected to a first power voltage line, and
   wherein an output terminal of the inverting circuit is connected to a gate terminal of an input switching element included in the first input circuit.
Clause 4: The level shifter of any preceding clause, wherein the buffer stage circuit further comprises a second input circuit configured to connect or disconnect one end of an output path comprising a node that outputs to a first ground voltage line the output voltage based on the input voltage, and to connect or disconnect one end of an inverting output path comprising a node that outputs the inverted output voltage to the first ground voltage line based on the inverted input voltage.
Clause 5: The level shifter of clause 4,
   wherein an input terminal of the inverting circuit is connected to an input voltage line,
   wherein a power terminal of the inverting circuit is connected to a first power voltage line, and
   wherein an output terminal of the inverting circuit is connected to a gate terminal of an input switching element included in the second input circuit.
Clause 6: The level shifter of any preceding clause, further comprising a bias voltage generating circuit connected to a second power supply voltage line and a first ground voltage line and configured to provide the first bias voltage through the first bias voltage line and to provide a second bias voltage through the second bias voltage line.
Clause 7: The level shifter of clause 6, wherein the bias voltage generating circuit is further configured to provide the first bias voltage without buffering the first bias voltage.
Clause 8: A level shifter comprising:
   an inverting circuit configured to invert an input voltage that swings between a first ground voltage and a first power supply voltage and to output an inverted input voltage;
   a first stage circuit configured to output a first intermediate voltage and a second intermediate voltage based on the input voltage and the inverted input voltage, wherein the first intermediate voltage swings between a second power supply voltage and a first bias voltage, and wherein the second intermediate voltage is an inverted voltage of the first intermediate voltage; and
   a second stage circuit configured to invert the first intermediate voltage, and to output an output voltage that swings between the first bias voltage and the second power supply voltage,
   wherein the first stage circuit comprises a first input circuit comprising a first input switching element connecting, to a first ground voltage line, one end of a first intermediate path comprising a node that outputs the first intermediate voltage to the second stage circuit,
   wherein the first input switching element is configured to be turned on based on the input voltage,
   wherein the first stage circuit further comprises a second input switching element connecting, to the first ground voltage line, one end of a second intermediate path comprising a node that outputs the second intermediate voltage to the second stage circuit, and
   wherein the second input switching element is configured to be turned on based on the inverted input voltage.
Clause 9: The level shifter of clause 8,
   wherein the second stage circuit is further configured to invert the second intermediate voltage to output an inverted output voltage that swings between the second power supply voltage and the first bias voltage,
   wherein the second stage circuit comprises a second input circuit that comprises a third input switching element connecting one end of an output path comprising a node that outputs the output voltage to the first ground voltage line,
   wherein the third input switching element is configured to be turned on based on the input voltage,
   wherein the second stage circuit further comprises a fourth input switching element connecting one end of an inverting output path comprising a node that outputs the inverted output voltage to the first ground voltage line, and
   wherein the fourth input switching element is configured to be turned on based on the inverted input voltage.
Clause 10: The level shifter of clause 9, wherein the second stage circuit further comprises an output protection circuit configured to, based on the input voltage and the inverted input voltage, adjust the output voltage to the first bias voltage or adjust the inverted output voltage to the first bias voltage.
Clause 11: The level shifter of clause 10, wherein the output protection circuit comprises:
   a first output protection switching element comprising a gate terminal connected to a second bias voltage line;
   a second output protection switching element comprising a gate terminal connected to the second bias voltage line;
   a third output protection switching element comprising a gate terminal connected to a first bias voltage line; and
   a fourth output protection switching element comprising a gate terminal connected to the first bias voltage line.
Clause 12: The level shifter of clause 11,
   wherein the first output protection switching element is connected to the third output protection switching element,
   wherein the third output protection switching element is connected to the third input switching element,
   wherein the second output protection switching element is connected to the fourth output protection switching element, and
   wherein the fourth output protection switching element is connected to the fourth input switching element.
Clause 13: The level shifter of any one of clauses 8 to 12, wherein the second stage circuit further comprises an output circuit configured to, based on the first intermediate voltage and the second intermediate voltage, adjust the output voltage to the second power supply voltage or adjust the inverted output voltage to the second power supply voltage.
Clause 14: The level shifter of any one of clauses 8 to 13,
   wherein an input terminal of the inverting circuit is connected to an input voltage line,
   wherein a power terminal of the inverting circuit is connected to a first power voltage line, and
   wherein an output terminal of the inverting circuit is connected to a gate terminal of the second input switching element.

While embodiments have been particularly shown and described, it will be understood that various changes in form and details may be made therein without departing from the scope of the invention as defined by the following claims.

## Claims

1. A level shifter (1) comprising:
an inverting circuit (110) configured to invert an input voltage (VIN) that swings between a first ground voltage (VG1) and a first power supply voltage (VDD1) and to output an inverted input voltage (VINB);
a level shifting stage circuit (120) configured to output a first intermediate voltage (VMID1) and a second intermediate voltage (VMID2), based on the input voltage (VIN) and the inverted input voltage (VINB); and
a buffer stage circuit (130) configured to invert the first intermediate voltage (VMID1) and the second intermediate voltage (VMID2), and to output an output voltage (VOUT) and an inverted output voltage (VOUTB), wherein the output voltage (VOUT) and the inverted output voltage (VOUTB) swing between a first bias voltage (VG1) and a second power supply voltage (VDD2),
wherein the level shifting stage circuit (120) comprises an input protection circuit (123) comprising a plurality of input protection switching elements (IPT1 - IPT4) each comprising a gate terminal connected to a first bias voltage line or a second bias voltage line, and
wherein the buffer stage circuit (130) comprises an output protection circuit (133) comprising a plurality of output protection switching elements (OPT1 - OPT4) each comprising a gate terminal connected to the first bias voltage line or the second bias voltage line.

2. The level shifter (1) of claim 1, wherein the level shifting stage circuit (120) further comprises a first input circuit (121) configured to connect or disconnect one end of a first intermediate path comprising a node (NMID1) that outputs the first intermediate voltage (VMID1) from a first ground voltage line, and to connect or disconnect one end of a second intermediate path comprising a node (NMID2) that outputs the second intermediate voltage (VMID2) from the first ground voltage line.

3. The level shifter (1) of claim 2,
wherein an input terminal of the inverting circuit (110) is connected to an input voltage line,
wherein a power terminal of the inverting circuit (110) is connected to a first power voltage line, and
wherein an output terminal of the inverting circuit (110) is connected to a gate terminal of an input switching element (IT2) included in the first input circuit (121).

4. The level shifter (1) of any preceding claim, wherein the buffer stage circuit (130) further comprises a second input circuit (131) configured to connect or disconnect one end of an output path comprising a node (NOMID5) that outputs to a first ground voltage line the output voltage (VOUT) based on the inverted input voltage (VINB), and to connect or disconnect one end of an inverting output path comprising a node (NOMID6) that outputs the inverted output voltage (VOUTB) to the first ground voltage line based on the input voltage (VIN).

5. The level shifter (1) of claim 4,
wherein an input terminal of the inverting circuit (110) is connected to an input voltage line,
wherein a power terminal of the inverting circuit (110) is connected to a first power voltage line, and
wherein an output terminal of the inverting circuit (110) is connected to a gate terminal of an input switching element (IT3) included in the second input circuit (131).

6. The level shifter (1) of any preceding claim, further comprising a bias voltage generating circuit (140) connected to a second power supply voltage line and a first ground voltage line and configured to provide the first bias voltage (VG1) through the first bias voltage line and to provide a second bias voltage (VG2) through the second bias voltage line.

7. The level shifter (1) of claim 6, wherein the bias voltage generating circuit is (140) further configured to provide the first bias voltage (VG1) without buffering the first bias voltage (VG1).

8. A level shifter (1) comprising:
an inverting circuit (110) configured to invert an input voltage (VIN) that swings between a first ground voltage (VG1) and a first power supply voltage (VDD1) and to output an inverted input voltage (VINB);
a first stage circuit (120) configured to output a first intermediate voltage (VMID1) and a second intermediate voltage (VMID2) based on the input voltage (VIN) and the inverted input voltage (VINB), wherein the first intermediate voltage (VMID1) swings between a second power supply voltage (VDD2) and a first bias voltage (VG1), and wherein the second intermediate voltage (VMID2) is an inverted voltage of the first intermediate voltage (VMID1); and
a second stage circuit (130) configured to invert the first intermediate voltage (VMID1), and to output an output voltage (VOUT) that swings between the first bias voltage (VG1) and the second power supply voltage (VDD2),
wherein the first stage circuit (120) comprises a first input circuit (121) comprising a first input switching element (IT1) connecting, to a first ground voltage line, one end of a first intermediate path comprising a node (NMID1) that outputs the first intermediate voltage (VMID1) to the second stage circuit (130),
wherein the first input switching element (IT1) is configured to be turned on based on the input voltage (VIN),
wherein the first stage circuit (120) further comprises a second input switching element (IT2) connecting, to the first ground voltage line, one end of a second intermediate path comprising a node (NMID2) that outputs the second intermediate voltage (VMID2) to the second stage circuit (130), and
wherein the second input switching element (IT2) is configured to be turned on based on the inverted input voltage (VINB).

9. The level shifter (1) of claim 8,
wherein the second stage circuit (130) is further configured to invert the second intermediate voltage (VMID2) to output an inverted output voltage (VOUTB) that swings between the second power supply voltage (VDD2) and the first bias voltage (VG1),
wherein the second stage circuit (130) comprises a second input circuit (131) that comprises a third input switching element (IT3) connecting one end of an output path comprising a node (NOMID5) that outputs the output voltage (VOUT) to the first ground voltage line,
wherein the third input switching element (IT3) is configured to be turned on based on the inverted input voltage (VINB),
wherein the second stage circuit (130) further comprises a fourth input switching element (IT4) connecting one end of an inverting output path comprising a node (NOMID6) that outputs the inverted output voltage (VOUTB) to the first ground voltage line, and
wherein the fourth input switching element (IT4) is configured to be turned on based on the input voltage (VIN).

10. The level shifter (1) of claim 9, wherein the second stage circuit (130) further comprises an output protection circuit (133) configured to, based on the input voltage (VIN) and the inverted input voltage (VINB), adjust the output voltage (VOUT) to the first bias voltage (VG1) or adjust the inverted output voltage (VOUTB) to the first bias voltage (VG1).

11. The level shifter (1) of claim 10, wherein the output protection circuit (133) comprises:
a first output protection switching element (OPT1) comprising a gate terminal connected to a second bias voltage line;
a second output protection switching element (OPT2) comprising a gate terminal connected to the second bias voltage line;
a third output protection switching element (OPT3) comprising a gate terminal connected to a first bias voltage line; and
a fourth output protection switching element (OPT4) comprising a gate terminal connected to the first bias voltage line.

12. The level shifter (1) of claim 11,
wherein the first output protection switching element (OPT1) is connected to the third output protection switching element (OPT3),
wherein the first output protection switching element (OPT1) is connected to the third input switching element (IT3),
wherein the second output protection switching element (OPT2) is connected to the fourth output protection switching element (OPT4), and
wherein the second output protection switching element (OPT2) is connected to the fourth input switching element (IT4).

13. The level shifter (1) of any one of claims 8 to 12, wherein the second stage circuit (130) further comprises an output circuit (135) configured to, based on the first intermediate voltage (VMID1) and the second intermediate voltage (VMID2), adjust the output voltage (VOUT) to the second power supply voltage (VDD2) or adjust the inverted output voltage (VOUTB) to the second power supply voltage (VDD2).

14. The level shifter (1) of any one of claims 8 to 13,
wherein an input terminal of the inverting circuit (110) is connected to an input voltage line,
wherein a power terminal of the inverting circuit (110) is connected to a first power voltage line, and
wherein an output terminal of the inverting circuit (110) is connected to a gate terminal of the second input switching element.

15. A level shifter (1) comprising:
an inverting circuit (110) configured to invert an input voltage (VIN) that swings between a first ground voltage (VG1) and a first power supply voltage (VDD1) and to output an inverted input voltage (VINB);
a first stage circuit (120) configured to output a first intermediate voltage (VMID1) and a second intermediate voltage (VMID2) based on the input voltage (VIN) and the inverted input voltage (VINB); and
a second stage circuit (130) configured to invert the first intermediate voltage (VMID1) and the second intermediate voltage (VMID2) to output an output voltage (VOUT) and an inverted output voltage (VOUTB),
wherein the output voltage (VOUT) and the inverted output voltage (VOUTB) swing between a first bias voltage (VG1) and a second power supply voltage (VDD2), and
wherein the second stage circuit (130) comprises an output protection circuit (133) configured to, based on the input voltage (VIN) and the inverted input voltage (VINB), adjust the output voltage (VOUT) to the first bias voltage (VG1) or adjust the inverted output voltage (VOUTB) to the first bias voltage (VG1).
